(19) Europäisches Patentamt
European Patent Office
Office européen des brevets

(11) **EP 4 756 867 A1**

(12) **EUROPEAN PATENT APPLICATION**
published in accordance with Art. 153(4) EPC

(43) Date of publication:
**10.06.2026 Bulletin 2026/24**

(21) Application number: **24851556.1**

(22) Date of filing: **18.07.2024**

(51) International Patent Classification (IPC):
**H01L 21/52** (2006.01)

(52) Cooperative Patent Classification (CPC):
**H10W 72/071**

(86) International application number:
**PCT/JP2024/025725**

(87) International publication number:
**WO 2025/033127 (13.02.2025 Gazette 2025/07)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **04.08.2023 JP 2023128052**

(71) Applicant: **Panasonic Intellectual Property Management Co., Ltd.**
**Kadoma-shi, Osaka 571-0057 (JP)**

(72) Inventors:
• **KITAURA, Hidetoshi**
**Kadoma-shi, Osaka 571-0057 (JP)**
• **NIIMI, Hideki**
**Kadoma-shi, Osaka 571-0057 (JP)**
• **FUJIMOTO, Taishi**
**Kadoma-shi, Osaka 571-0057 (JP)**

(74) Representative: **Grünecker Patent- und Rechtsanwälte**
**PartG mbB**
**Leopoldstraße 4**
**80802 München (DE)**

(54) **JOINING SHEET, SEMICONDUCTOR DEVICE, METHOD FOR MANUFACTURING SEMICONDUCTOR DEVICE, AND APPARATUS FOR MANUFACTURING SEMICONDUCTOR DEVICE**

(57) A bonding sheet (10) is one of a pair of sheets for bonding a first member and a second member, and includes a first main surface (11) to be bonded to the first member or the second member; a second main surface (12) at a side opposite to the first main surface (11). The second main surface (12) is inclined with respect to the first main surface (11). The bonding sheet (10) is conductive.

FIG. 2

EP 4 756 867 A1

## Description

[Technical Field]

The present disclosure relates to a bonding sheet, a semiconductor device, a method of manufacturing the semiconductor device, and an apparatus for manufacturing the semiconductor device.

[Background Art]

Patent Literatures (PTL) 1 to 3 each disclose a double-sided heat dissipation structure including a semiconductor chip sandwiched between two substrates. The heat generated by the semiconductor chip is transferred to the two substrates, improving the heat dissipation.

[Citation List]

[Patent Literatures]

[0003]

　　　[PTL 1] International Publication No. WO2022/049641
　　　[PTL 2] Japanese Unexamined Patent Application Publication No.2021-2563
　　　[PTL 3] Japanese Unexamined Patent Application Publication No. 2021-180290

[Summary of Invention]

[Technical Problems]

There may be variations in the placement of members such as semiconductor chips if sandwiched between two substrates. Examples of the variations include the case where one of semiconductor chips is inclined or semiconductor chips are at different heights. The variations in the placement of members may be caused by the accuracy in process of placing the members, size variations of the members, or other factors. The variations in the placement of members may cause a poor connection between the member and the two substrates, for example. The poor connection may lead to deterioration in mechanical, thermal and/or electrical characteristics.

To address the problems, the present disclosure provides a bonding sheet, a semiconductor device, a method of manufacturing the semiconductor device, and an apparatus for manufacturing the semiconductor device that can absorb the variations in the placement of members.

[Solution to Problems]

A bonding sheet according to an aspect of the present disclosure is one of a pair of sheets for bonding a first member and a second member. The bonding sheet includes: a first main surface to be bonded to the first member or the second member; and a second main surface at a side opposite to the first main surface. The second main surface is inclined with respect to the first main surface. The bonding sheet is conductive.

A semiconductor device according to an aspect of the present disclosure includes: a pair of sheets including a first bonding sheet and a second bonding sheet each being the bonding sheet according to the aspect described above; the first member; and the second member. The first member is a semiconductor element or a spacer. The first main surface of the first bonding sheet is bonded to the first member. The first main surface of the second bonding sheet is bonded to the second member. The second main surfaces of the first bonding sheet and the second bonding sheet are bonded to each other.

A method of manufacturing the semiconductor device according to an aspect of the present disclosure includes: preparing pairs of sheets each including a first bonding sheet and a second bonding sheet, each being the bonding sheet according to the aspect described above; preparing a first substrate on which a plurality of first members, each being the first member, are placed not to overlap each other in a plan view; measuring at least one of heights of upper surfaces of the plurality of first members from the first substrate or inclinations of upper surfaces of the plurality of first members with respect to the first substrate; placing the pairs of sheets on the upper surfaces of corresponding ones of the plurality of first members; and placing a second substrate that is the second member so as to cover the pairs of sheets. The placing of the pairs of sheets includes placing the second main surfaces of at least one of the pairs of sheets in a displaced manner based on at least one of the heights or the inclinations of the upper surfaces of the plurality of first members.

A method of manufacturing the semiconductor device according to another aspect of the present disclosure includes: preparing a pair of sheets including a first bonding sheet and a second bonding sheet, each being the bonding sheet according to the aspect described above; preparing a first substrate provided with the first member; measuring an inclination of an upper surface of the first member with respect to the first substrate; placing the pair of sheets on the upper surface of the first member, while displacing one of the first bonding sheet or the second bonding sheet from an other one of the first bonding sheet or the second bonding sheet in a direction of rotation about an axis extending in a direction orthogonal to the second main surface based on the inclination; and placing a second substrate that is the second member so as to cover the pair of sheets.

An apparatus for manufacturing the semiconductor device according to an aspect of the present disclosure includes: a first mounter that places pairs of sheets each including a first bonding sheet and a second bonding sheet, each being the bonding sheet according to the aspect described above, on upper surfaces of a plurality of first members, each being the first member, placed on a first substrate not to overlap each other in a plan view; a second mounter that places a second substrate that is the second member so as to cover the pairs of sheets; and a measure that measures at least one of heights of the upper surfaces of the plurality of first members from the first substrate or inclinations of the upper surfaces of the plurality of first members with respect to the first substrate. The first mounter places the second main surfaces of at least one of the pairs of sheets in a displaced manner based on at least one of the heights or the inclinations of the upper surfaces of the plurality of first members.

An apparatus for manufacturing the semiconductor device according to another aspect of the present disclosure includes: a first mounter that places a pair of sheets including a first bonding sheet and a second bonding sheet, each being the bonding sheet according to the aspect described above, on an upper surface of the first member on a first substrate; a second mounter that places a second substrate that is the second member so as to cover the pair of sheets; and a measure that measures an inclination of the upper surface of the first member with respect to the first substrate. The first mounter places the pair of sheets on the upper surface of the first member, while displacing one of the first bonding sheet or the second bonding sheet from another in a direction of rotation about an axis extending in a direction orthogonal to the second main surface based on the inclination.

An aspect of the present disclosure is implemented as a program for causing a computer to executed the manufacturing method described above. Alternatively, an aspect of the present disclosure is implemented as a computer-readable non-transitory recording medium that stores the program.

[Advantageous Effects of Invention]

The present disclosure can absorb variations in the placement of members.

[Brief Description of Drawings]

[FIG. 1]

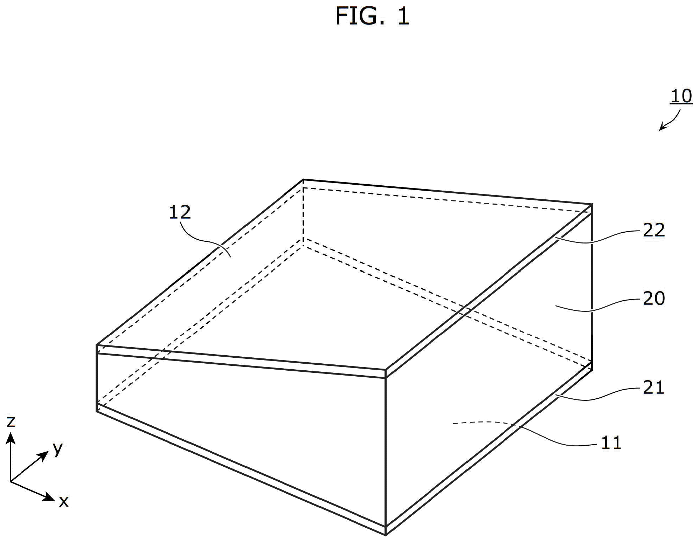

FIG. 1 is a perspective view of a bonding sheet according to Embodiment 1.
[FIG. 2]

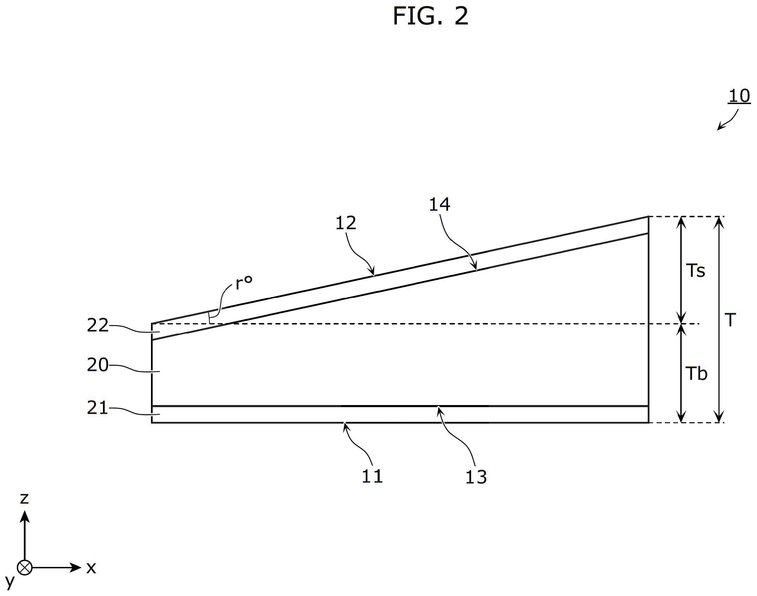

FIG. 2 is a side view of the bonding sheet according to Embodiment 1.
[FIG. 3A]

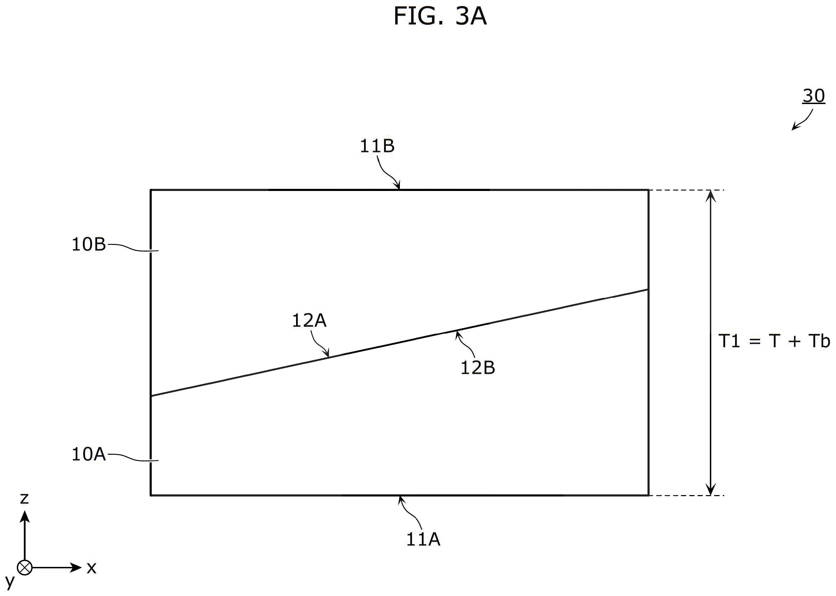

FIG. 3A is a side view of a bonding sheet pair according to Embodiment 1 in a first bonding state.
[FIG. 3B]

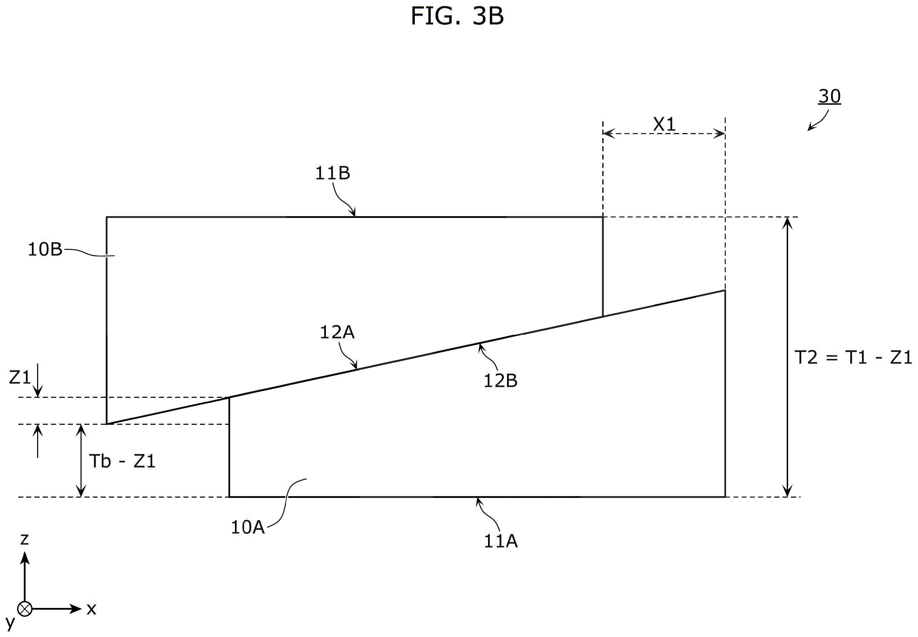

FIG. 3B is a side view of the bonding sheet pair according to Embodiment 1 in a second bonding state.
[FIG. 3C]

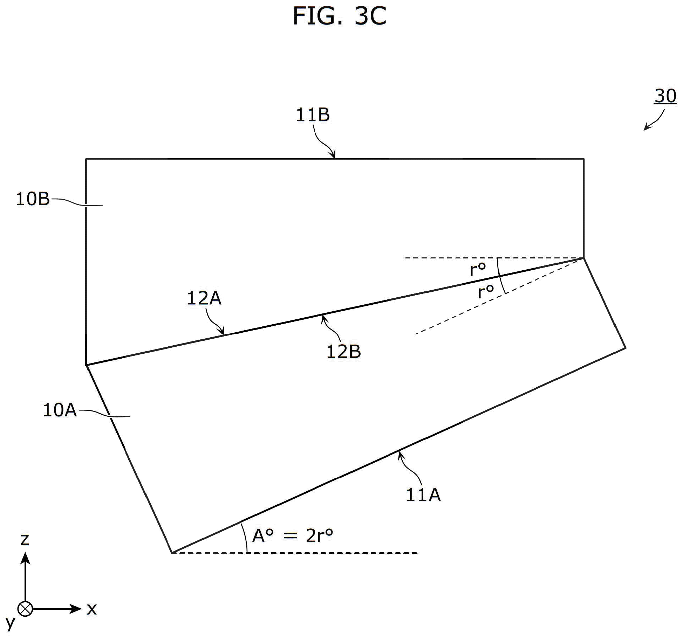

FIG. 3C is a side view of the bonding sheet pair according to Embodiment 1 in a third bonding state.
[FIG. 4A]

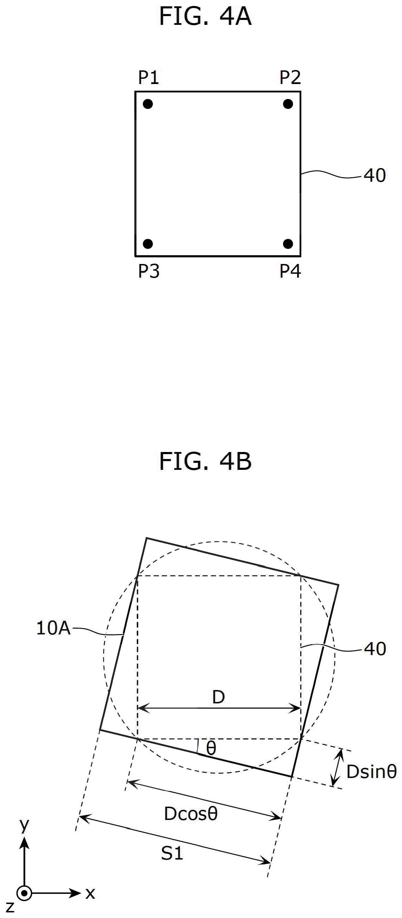

FIG. 4A is a plan view a semiconductor chip to be bonded to the bonding sheet according to Embodiment 1.
[FIG. 4B]
FIG. 4B is a plan view for illustrating a size relationship between the bonding sheet according to Embodiment 1 and the semiconductor chip.
[FIG. 5]

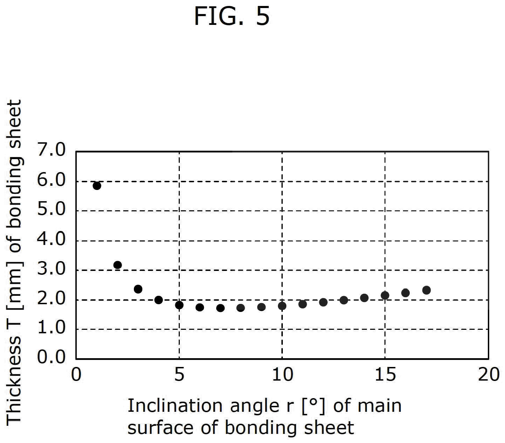

FIG. 5 shows a relationship between an inclination angle of a second main surface of the bonding sheet and a thickness of the bonding sheet according to Embodiment 1.
[FIG. 6]

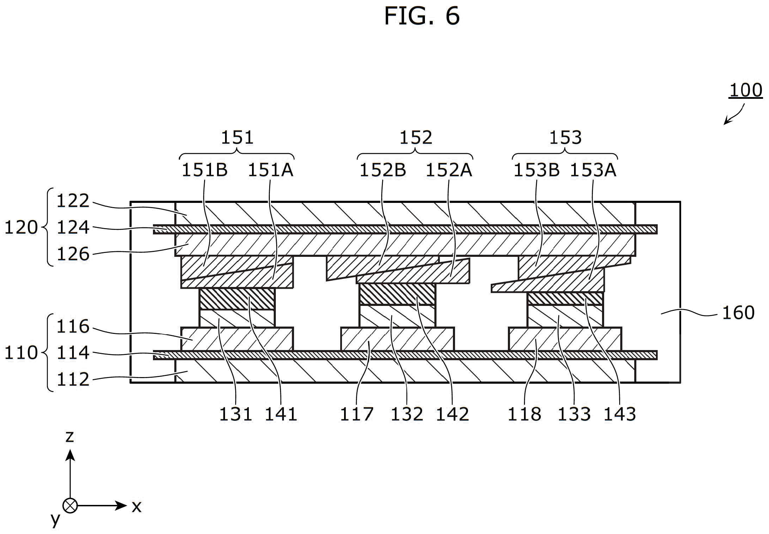

FIG. 6 is a cross-sectional view of a semiconductor device according to Embodiment 2.
[FIG. 7]

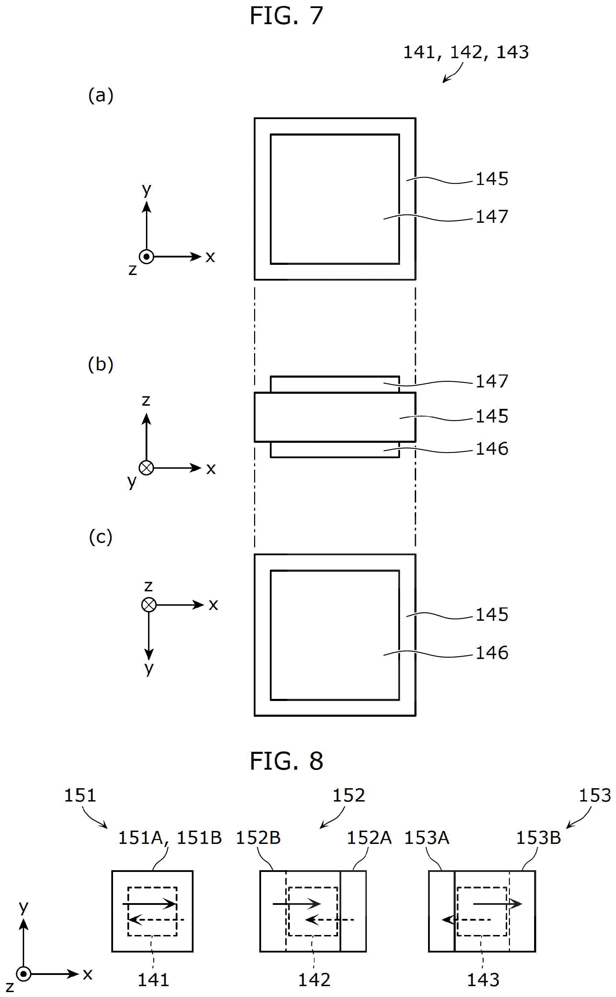

FIG. 7 includes a top view, a side view, and a bottom view showing a configuration of a semiconductor chip of the semiconductor device according to Embodiment 2.

[FIG. 8]

FIG. 8 is a plan view showing bonding states of a plurality of bonding sheet pairs of the semiconductor device according to Embodiment 2.

[FIG. 9]

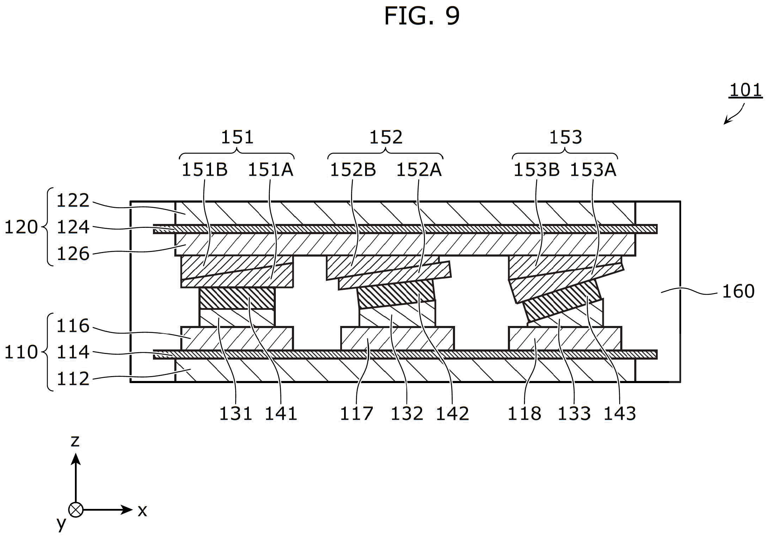

FIG. 9 is a cross-sectional view showing another example of the semiconductor device according to Embodiment 2.

[FIG. 10]

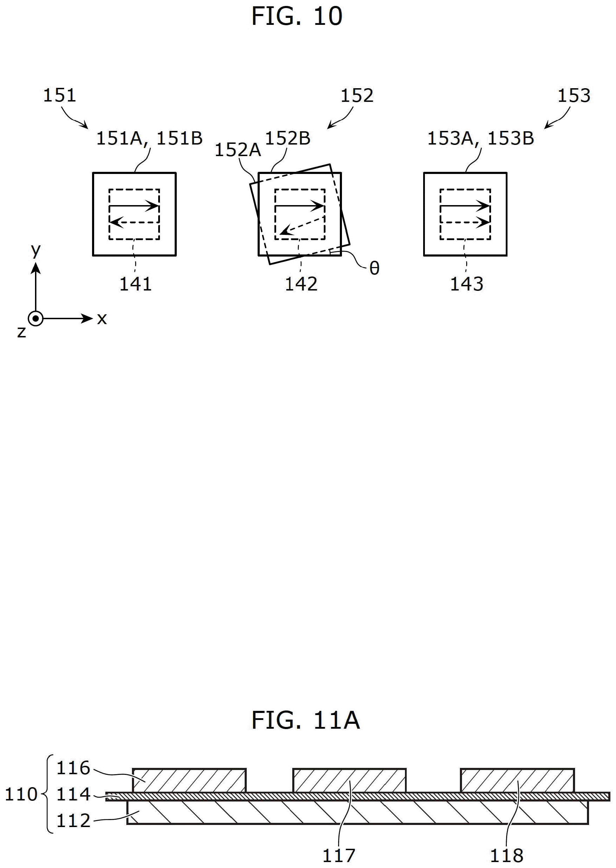

FIG. 10 is a plan view showing bonding states of a plurality of bonding sheet pairs of the semiconductor device according to Embodiment 2.

[FIG. 11A]

FIG. 11A is a cross-sectional view for illustrating a step (i.e., preparing a lower substrate) of a method of manufacturing the semiconductor device according to Embodiment 2.

[FIG. 11B]

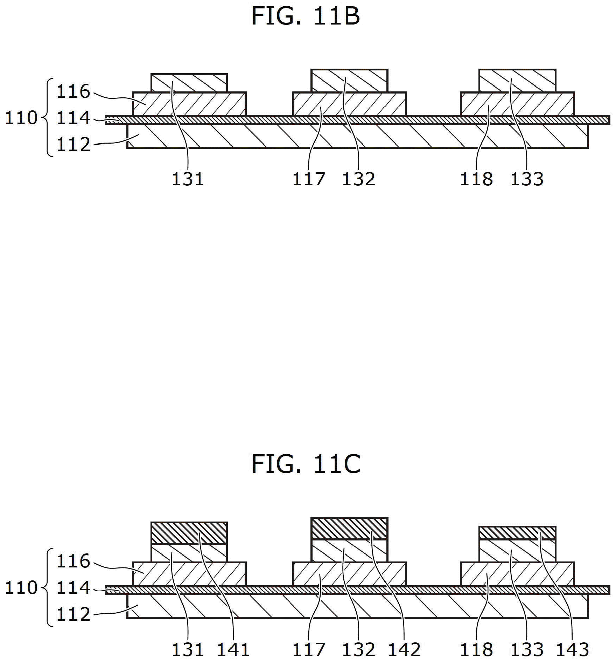

FIG. 11B is a cross-sectional view for illustrating another step (i.e., forming bonding materials) of the method of manufacturing the semiconductor device according to Embodiment 2.

[FIG. 11C]

FIG. 11C is a cross-sectional view for illustrating another step (i.e., mounting chips) of the method of manufacturing the semiconductor device according to Embodiment 2.

[FIG. 11D]

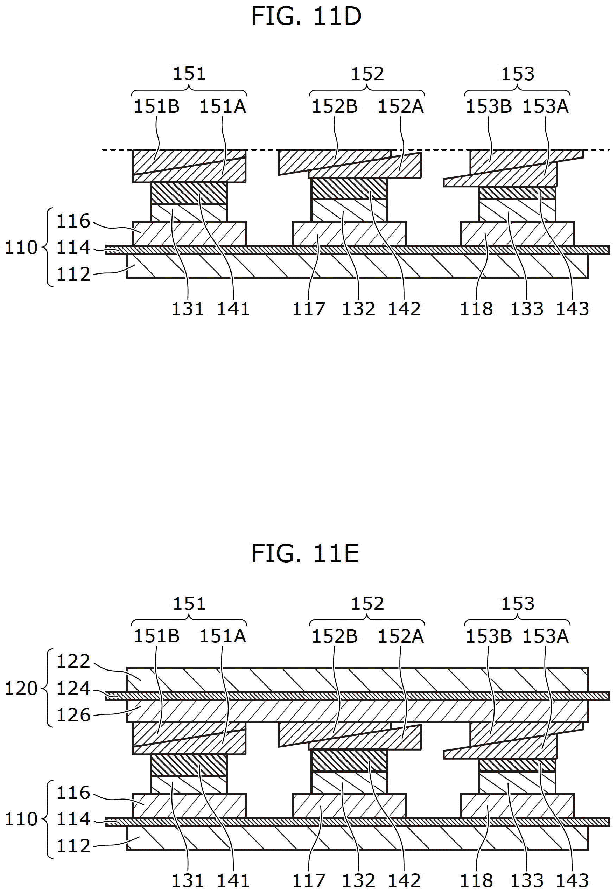

FIG. 11D is a cross-sectional view for illustrating another step (i.e., placing bonding sheet pairs) of the method of manufacturing the semiconductor device according to Embodiment 2.

[FIG. 11E]

FIG. 11E is a cross-sectional view for illustrating another step (i.e., placing an upper substrate) of the method of manufacturing the semiconductor device according to Embodiment 2.

[FIG. 12]

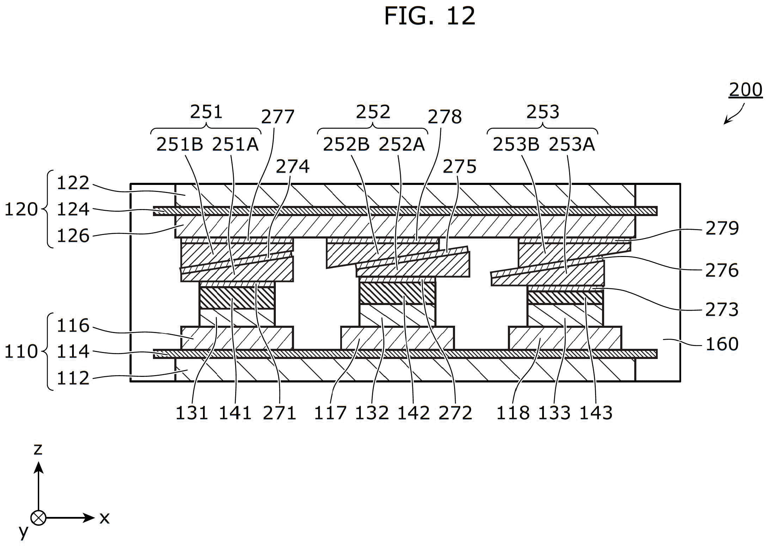

FIG. 12 is a cross-sectional view of a semiconductor device according to Embodiment 3.

[FIG. 13]

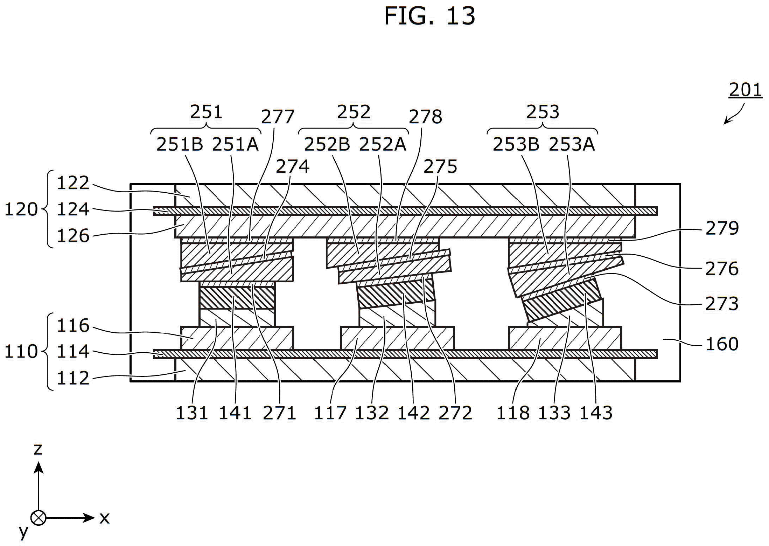

FIG. 13 is a cross-sectional view showing another example of the semiconductor device according to Embodiment 3.

[FIG. 14A]

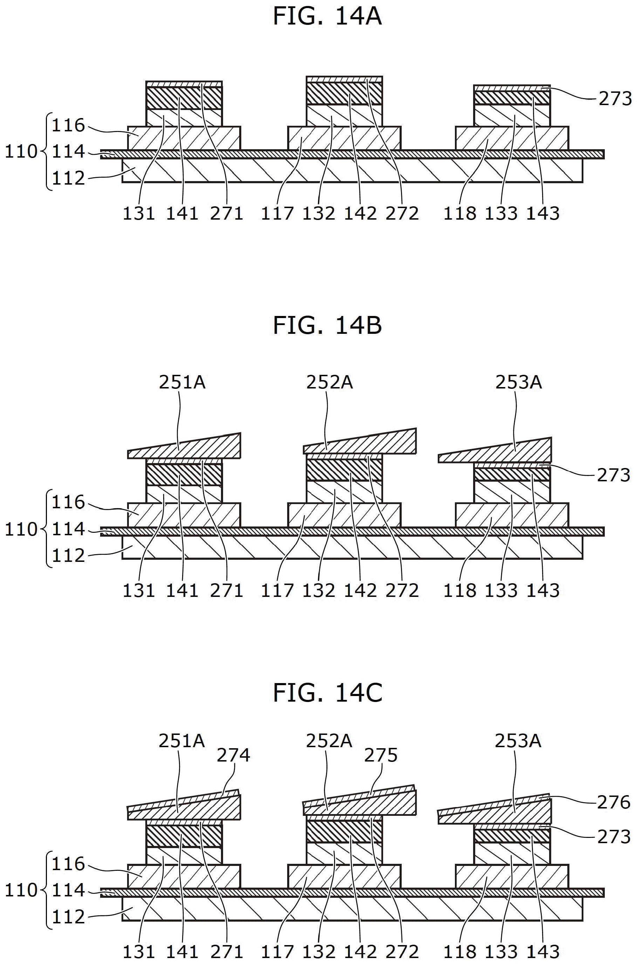

FIG. 14A is a cross-sectional view for illustrating a step (i.e., placing conductive paste) of s method of manufacturing the semiconductor device according to Embodiment 3.

[FIG. 14B]

FIG. 14B is a cross-sectional view for illustrating another step (i.e., placing first bonding sheets) of the method of manufacturing the semiconductor device according to Embodiment 3.

[FIG. 14C]

FIG. 14C is a cross-sectional view for illustrating another step (i.e., placing conductive paste) of the method of manufacturing the semiconductor device according to Embodiment 3.

[FIG. 14D]

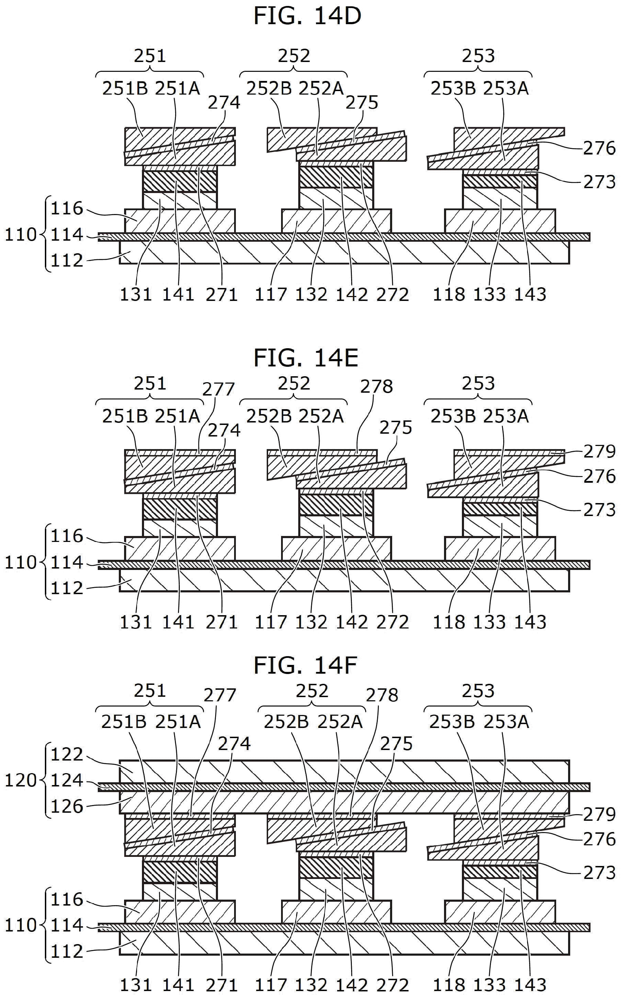

FIG. 14D is a cross-sectional view for illustrating another step (i.e., placing second bonding sheets) of the method of manufacturing the semiconductor device according to Embodiment 3.

[FIG. 14E]

FIG. 14E is a cross-sectional view for illustrating another step (i.e., placing conductive paste) of the method of manufacturing the semiconductor device according to Embodiment 3.

[FIG. 14F]

FIG. 14F is a cross-sectional view for illustrating another step (i.e., placing an upper substrate) of the method of manufacturing the semiconductor device according to Embodiment 3.

[FIG. 15]

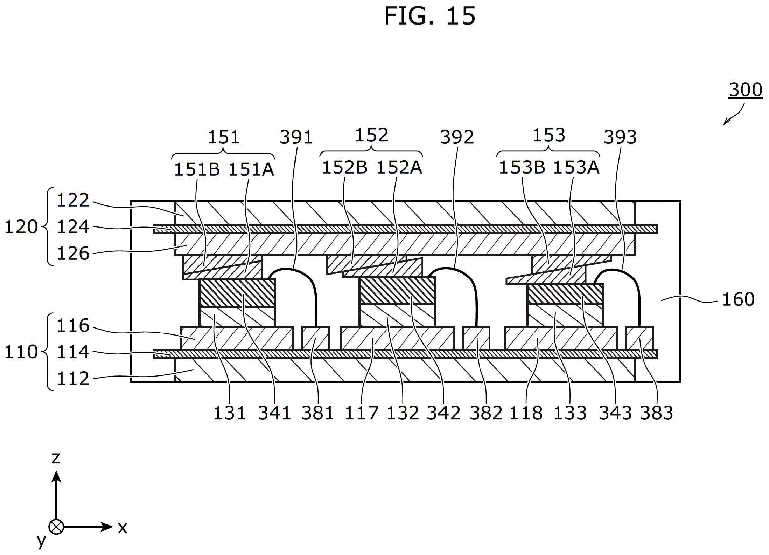

FIG. 15 is a cross-sectional view of a semiconductor device according to Embodiment 4.

[FIG. 16]

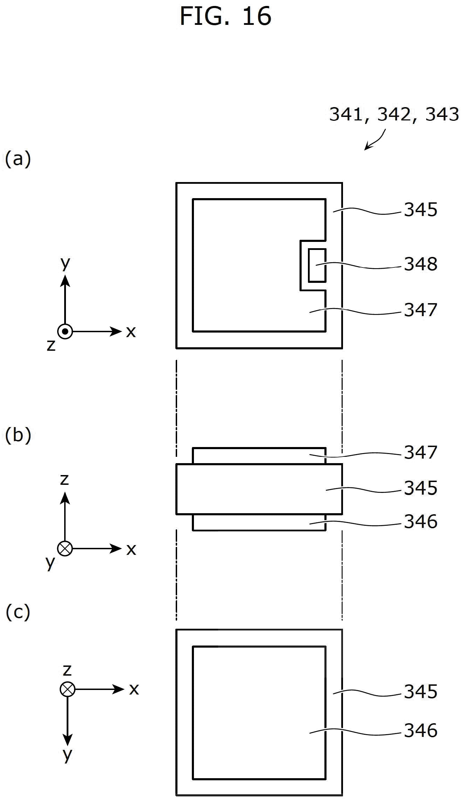

FIG. 16 includes a top view, a side view, and a bottom view showing a configuration of a semiconductor chip of the semiconductor device according to Embodiment 4 .

[FIG. 17]

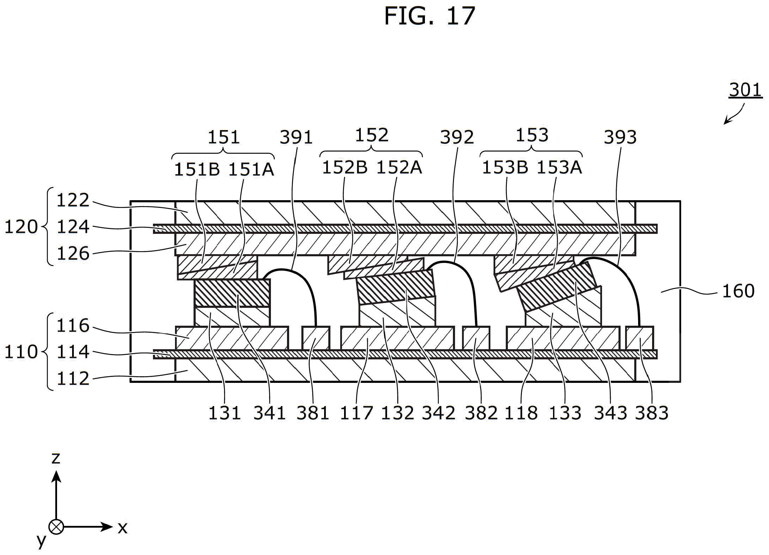

FIG. 17 is a cross-sectional view showing another example of the semiconductor device according to Embodiment 4.

[FIG. 18A]

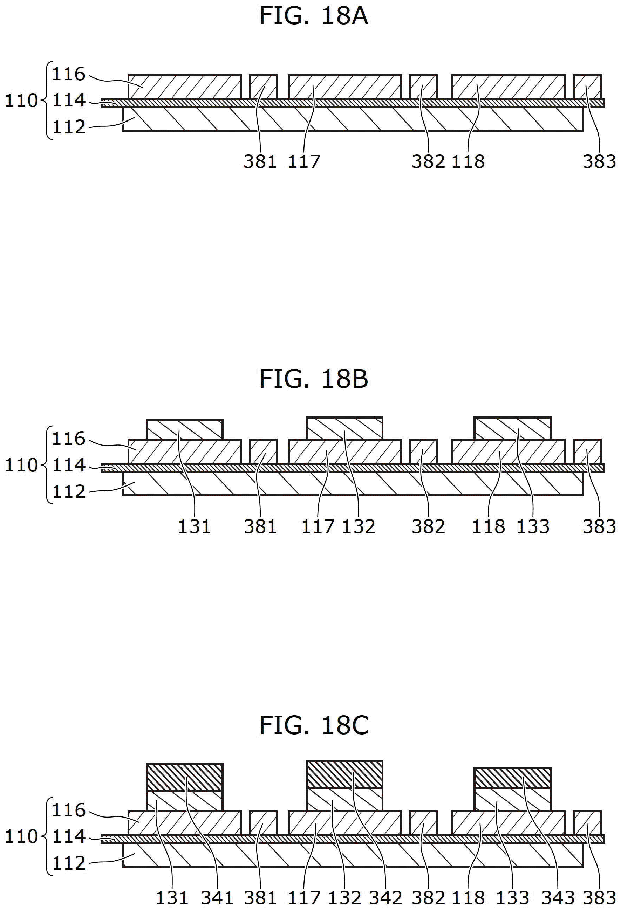

FIG. 18A is a cross-sectional view for illustrating a step (i.e., preparing a lower substrate) of a method of manufacturing the semiconductor device according to Embodiment 4.

[FIG. 18B]

FIG. 18B is a cross-sectional view for illustrating another step (i.e., forming bonding materials) of the method of manufacturing the semiconductor device according to Embodiment 4.
[FIG. 18C]
FIG. 18C is a cross-sectional view for illustrating another step (i.e., mounting chips) of the method of manufacturing the semiconductor device according to Embodiment 4.
[FIG. 18D]

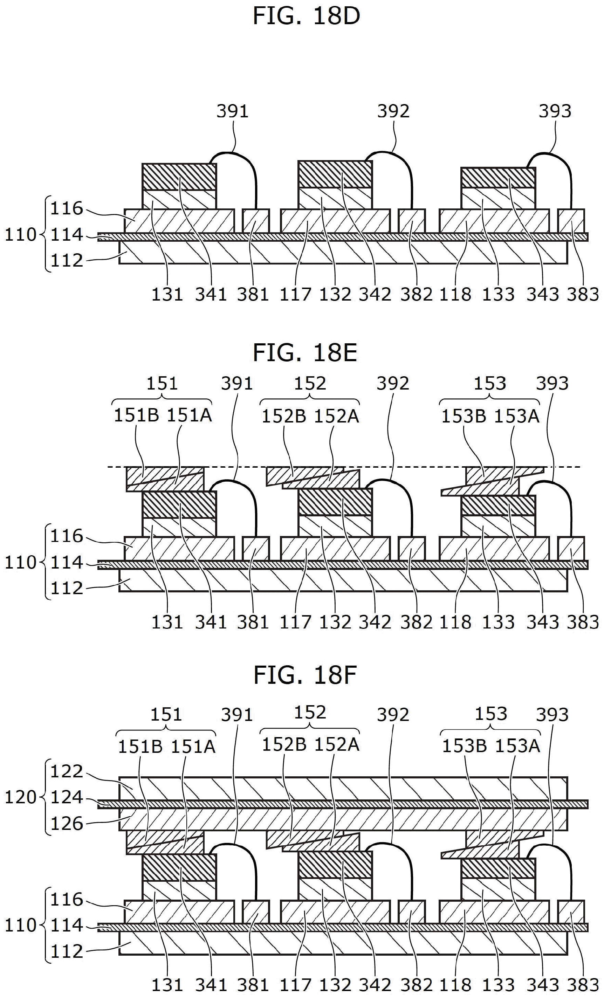

FIG. 18D is a cross-sectional view for illustrating another step (i.e., bonding wires) of the method of manufacturing the semiconductor device according to Embodiment 4.
[FIG. 18E]
FIG. 18E is a cross-sectional view for illustrating another step (placing bonding sheet pairs) of the method of manufacturing the semiconductor device according to Embodiment 4.
[FIG. 18F]
FIG. 18F is a cross-sectional view for illustrating another step (i.e., placing an upper substrate) of the method of manufacturing the semiconductor device according to Embodiment 4.
[FIG. 19]

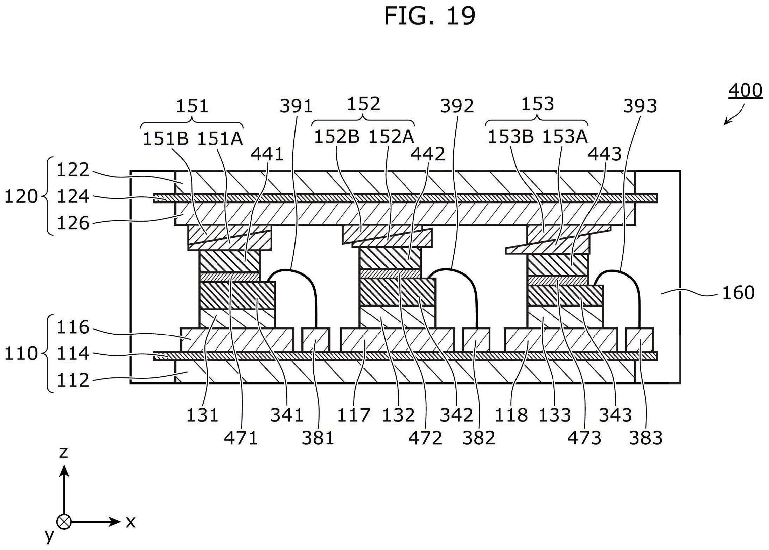

FIG. 19 is a cross-sectional view of a semiconductor device according to Embodiment 5.
[FIG. 20]

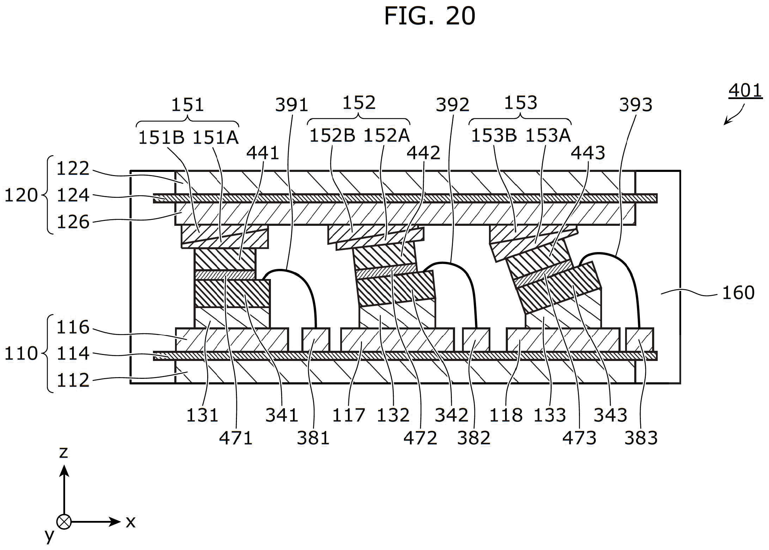

FIG. 20 is a cross-sectional view showing another example of the semiconductor device according to Embodiment 5.
[FIG. 21]

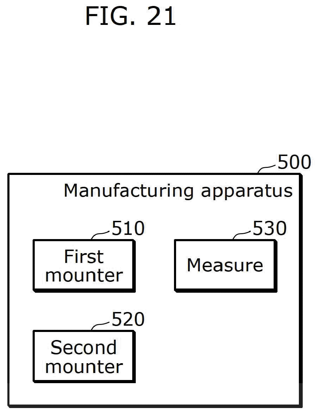

FIG. 21 is a block diagram of an apparatus for manufacturing a semiconductor device according to Embodiment 6.
[FIG. 22]

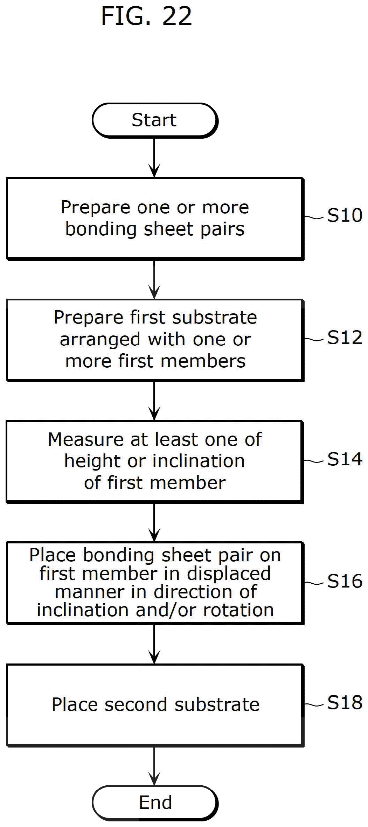

FIG. 22 is a flowchart showing a method of manufacturing the semiconductor device according to Embodiment 6.
[FIG. 23A]

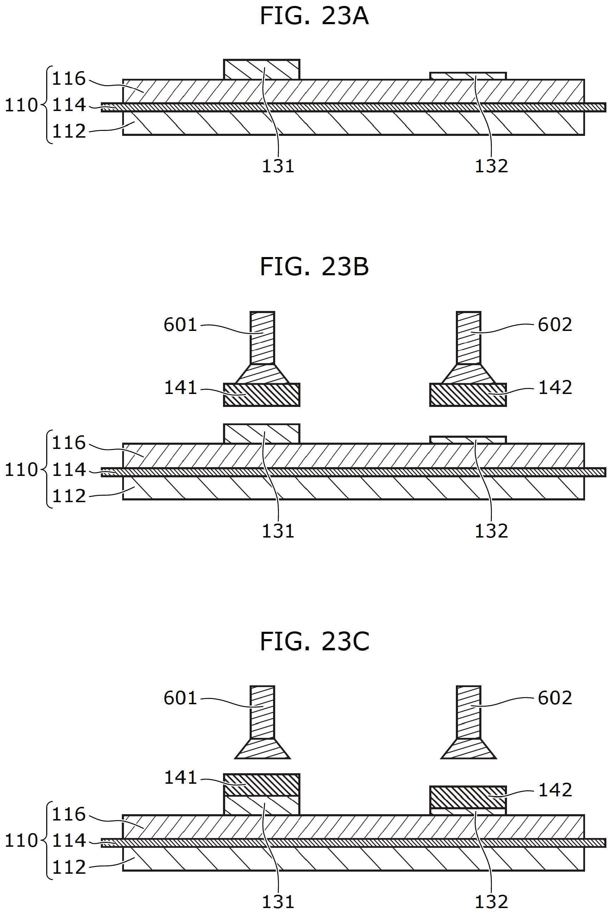

FIG. 23A is a cross-sectional view for illustrating a step (i.e., preparing a lower substrate) in an operation of the apparatus for manufacturing the semiconductor device according to Embodiment 6.
[FIG. 23B]
FIG. 23B is a cross-sectional view for illustrating another step (i.e., holding chips) in the operation of the apparatus for manufacturing the semiconductor device according to Embodiment 6.
[FIG. 23C]
FIG. 23C is a cross-sectional view for illustrating another step (i.e., placing the chips) in the operation of the apparatus for manufacturing the semiconductor device according to Embodiment 6.
[FIG. 23D]

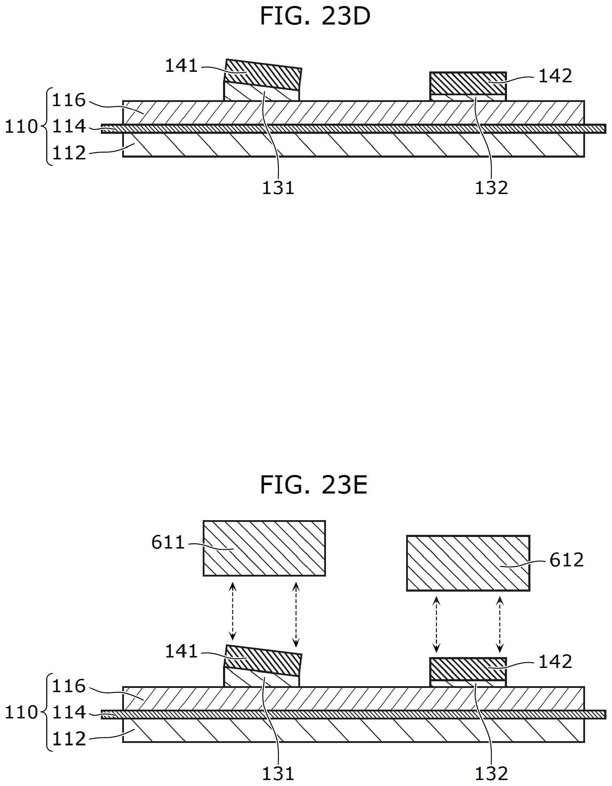

FIG. 23D is a cross-sectional view for illustrating another step (i.e., bonding) in the operation of the apparatus for manufacturing the semiconductor device according to Embodiment 6.
[FIG. 23E]
FIG. 23E is a cross-sectional view for illustrating another step (measuring) in the operation of the apparatus for manufacturing the semiconductor device according to Embodiment 6.
[FIG. 23F]

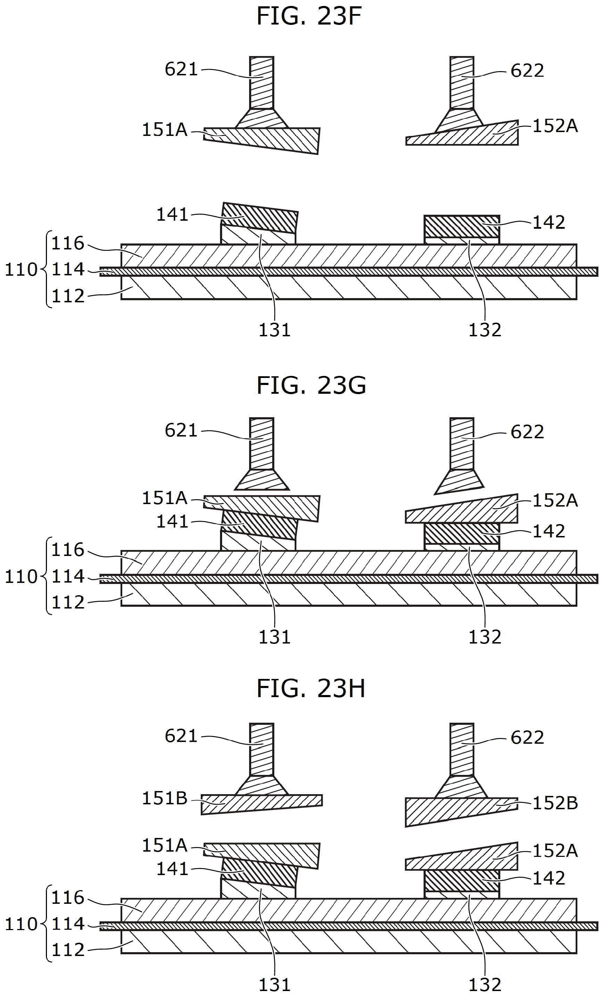

FIG. 23F is a cross-sectional view for illustrating another step (i.e., holding first bonding sheets) in the operation of the apparatus for manufacturing the semiconductor device according to Embodiment 6.
[FIG. 23G]
FIG. 23G is a cross-sectional view for illustrating another step (i.e., placing the first bonding sheets) in the operation of the apparatus for manufacturing the semiconductor device according to Embodiment 6.
[FIG. 23H]
FIG. 23H is a cross-sectional view for illustrating another step (i.e., holding second bonding sheets) in the operation of the apparatus for manufacturing the semiconductor device according to Embodiment 6.
[FIG. 23I]

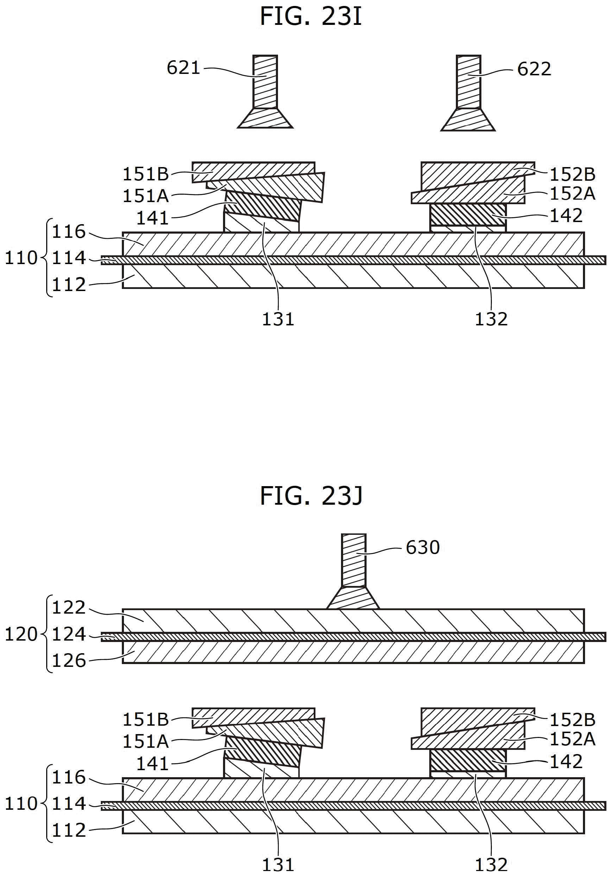

FIG. 23I is a cross-sectional view for illustrating another step of the operation (i.e., placing the second boning sheets) of the apparatus for manufacturing the semiconductor device according to Embodiment 6.
[FIG. 23J]
FIG. 23J is a cross-sectional view for illustrating another step (i.e., holding an upper substrate) in the operation of the apparatus for manufacturing the semiconductor device according to Embodiment 6.
[FIG. 23K]

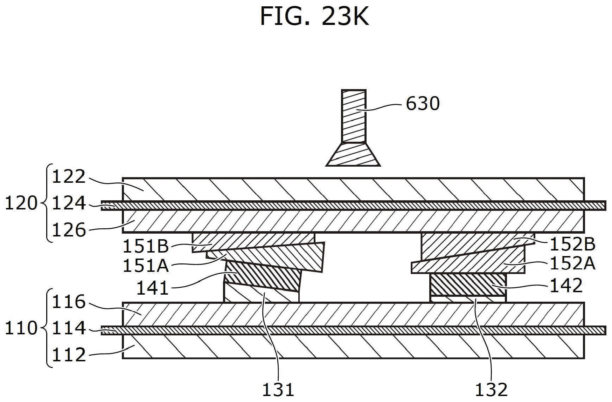

FIG. 23K is a cross-sectional view for illustrating another step (i.e., placing the upper substrate) in the operation of the apparatus for manufacturing the semiconductor device according to Embodiment 6.
[FIG. 24]

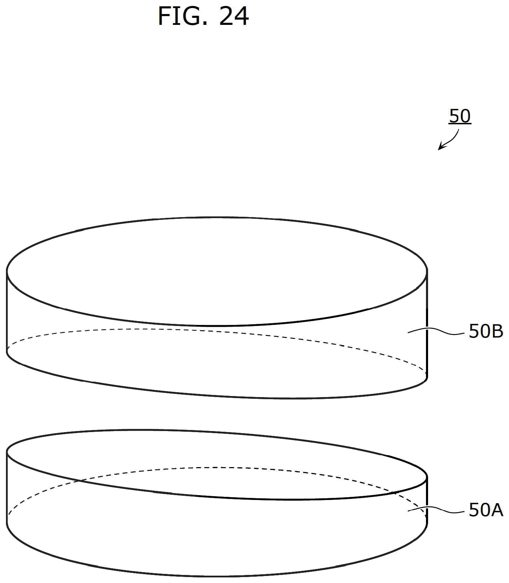

FIG. 24 is a perspective view showing a variation of the bonding sheet pair.

[Description of Embodiments]

[Outline of Present Disclosure]

A bonding sheet according to a first aspect of the present disclosure is one of a pair of sheets for bonding a first member and a second member. The bonding sheet includes: a first main surface to be bonded to the first member or the second member; and a second main surface at a side opposite to the first main surface. The second main surface is inclined with respect to the first main surface. The bonding sheet is conductive.

If the bonding sheet is used together with another bonding sheet, this configuration can change the distance and inclination between the first main surfaces by adjusting the positional relationship between the second main surfaces. Accordingly, by placing the bonding sheets with a suitable positional relationship in accordance with the locations of members to be bonded, the variations in the placement of the members can be absorbed.

A bonding sheet according to a second aspect of the present disclosure is an embodiment of the bonding sheet according to the first aspect. In the second aspect, the bonding sheet further includes: a metal layer having a third main surface, and a fourth main surface at a side opposite to the third main surface; a first covering layer that covers at least a part of the third main surface; and a second covering layer that covers at least a part of the fourth main surface. The first main surface is a part of a surface of the first covering layer. The second main surface is a part of a surface of the second covering layer.

This configuration can utilize the first covering layer and the second covering layer to bond a member with another member or another bonding sheet. The bonding process can be performed simply and accurately by providing the covering layers for bonding in a metal layer in advance.

A bonding sheet according to a third aspect of the present disclosure is an embodiment of the bonding sheet according to the second aspect. In the third aspect, each of the first covering layer and the second covering layer contains tin or a tin alloy as a main component.

This configuration can utilize a covering layer with a desired thickness easily and accurately by plating or any other suitable process. Reflow treatment through formic acid reduction or hydrogen reduction can strengthen the thermal, mechanical, and electrical bonding.

A bonding sheet according to a fourth aspect of the present disclosure is an embodiment of the bonding sheet according to the second or third aspect. In the fourth aspect, the third main surface is parallel to the first main surface. The fourth main surface is parallel to the second main surface.

With this configuration, the shape of the metal layer can define the shape of the bonding sheet. The dimensional accuracy of the bonding sheet can be improved by forming the metal layer in a predetermined shape using a mold, for example.

A semiconductor device according to a fifth aspect of the present disclosure includes: a pair of sheets including a first bonding sheet and a second bonding sheet each being the bonding sheet according to any one of the first to fourth aspects; the first member; and the second member. The first member is a semiconductor element or a spacer. The first main surface of the first bonding sheet is bonded to the first member. The first main surface of the second bonding sheet is bonded to the second member. The second main surfaces of the first bonding sheet and the second bonding sheet are bonded to each other.

This configuration can change the distance and inclination between the first main surfaces of the first and second bonding sheets by adjusting the positional relationship between the second main surfaces of the first and second bonding sheets. Accordingly, by placing the first and second bonding sheets with a suitable positional relationship in accordance with the locations of the first members, the variations in the placement of the first members can be absorbed.

A semiconductor device according to a sixth aspect of the present disclosure is an embodiment of the semiconductor device according to the fifth aspect. In the sixth aspect, the second member is a substrate or a spacer.

A semiconductor device according to a seventh aspect of the present disclosure is an embodiment of the semiconductor device according to the fifth or sixth aspect. In the seventh aspect, the first main surface of the first bonding sheet is larger than the first member in a plan view of the first main surface.

This configuration can cover the entire upper surface of the first member with the bonding sheet, providing excellent thermal, mechanical, and electrical bonding to the first member.

A semiconductor device according to an eighth aspect of the present disclosure is an embodiment of the semiconductor device according to any one of the fifth to seventh aspects. In the eighth aspect, the semiconductor device further includes: a first substrate; a second substrate being the second member parallel to the first substrate; a plurality of first members, each being the first member, placed between the first substrate and the second substrate so as not to overlap each other in a plan view of the first substrate; and pairs of sheets, each being the pair of sheets, in one-to-one correspondence to the plurality of first members. In each of the pairs of sheets, the first main surface of the first bonding sheet is bonded to a corresponding one of the plurality of first members, and the first main surface of the second bonding sheet is bonded to the second substrate.

With this configuration, if the plurality of first members are placed, there may be variations in the placement due to size differences of the first members and the accuracy in the process of placing the first members. Utilizing the pairs of sheets according to the present disclosure, the variations in the placement of the first members can be absorbed. The first substrate and the second substrate can be easily kept in parallel to each other, and the device sizes and heat dissipation can be set to target design values.

A semiconductor device according to a ninth aspect of the present disclosure is an embodiment of the semiconductor device according to the eighth aspect. In the ninth aspect, in at least one of the pairs of sheets, one of the second main surfaces is bonded in a displaced manner from another one of the second main surfaces.

This configuration can absorb the variations in the placement of the first members by adjusting the bonding state between the bonding sheets in accordance with the variations in the placement of the first members.

A semiconductor device according to a tenth aspect of the present disclosure is an embodiment of the semiconductor device according to the ninth aspect. In the tenth aspect, the second main surfaces are displaced in a direction of inclination between the second main surfaces.

This configuration can absorb the height differences of the plurality of first members by adjusting the thicknesses of the pair of sheets.

A semiconductor device according to an eleventh aspect of the present disclosure is an embodiment of the semiconductor device according to the ninth or tenth aspect. In the eleventh aspect, the second main surfaces are displaced in a direction of rotation about an axis extending in a direction orthogonal to the second main surfaces.

This configuration can absorb the inclinations of the first members by adjusting the inclinations of the main surfaces of the pair of sheets.

A semiconductor device according to a twelfth aspect of the present disclosure is an embodiment of the semiconductor device according to any one of the ninth to eleventh aspects. In the twelfth aspect, surfaces of at least two of the plurality of first members bonded to corresponding ones of the first main surfaces are at different heights from the first substrate.

Even if the plurality of first members have bonding surfaces at different heights, this configuration can absorb the height differences by adjusting the bonding states between the pairs of sheets.

A semiconductor device according to a thirteenth aspect of the present disclosure is an embodiment of the semiconductor device according to any one of the ninth to twelfth aspects. In the thirteenth aspect, a surface of at least one of the plurality of first members bonded to a corresponding one of the first main surfaces is inclined with respect to the first substrate.

Even if the bonding surface of one of the first members is inclined, this configuration can absorb the inclination by adjusting the bonding state between the corresponding pair of sheets.

A method of manufacturing a semiconductor device according to a fourteenth aspect of the present disclosure includes: preparing pairs of sheets each including a first bonding sheet and a second bonding sheet, each being the bonding sheet according to any one of the first to fourth aspects; preparing a first substrate on which a plurality of first members, each being the first member, are placed not to overlap each other in a plan view; measuring at least one of heights of upper surfaces of the plurality of first members from the first substrate or inclinations of upper surfaces of the plurality of first members with respect to the first substrate; placing the pairs of sheets on the upper surfaces of corresponding ones of the plurality of first members; and placing a second substrate that is the second member so as to cover the pairs of sheets. The placing of the pairs of sheets includes placing the second main surfaces of at least one of the pairs of sheets in a displaced manner based on at least one of the heights or the inclinations of the upper surfaces of the plurality of first members.

This method can change the distance and inclination between the first main surfaces of the first and second bonding sheets by adjusting the positional relationship between the second main surfaces of the first and second bonding sheets. Accordingly, by placing the first and second bonding sheets with a suitable positional relationship in accordance with the locations of the first members, the variations in the placement of the first members can be absorbed.

A method of manufacturing a semiconductor device according to a fifteenth aspect of the present disclosure is an embodiment of the method of manufacturing a semiconductor device according to the fourteenth aspect. In the fifteenth aspect, the placing of the pairs of sheets includes: specifying directions and amounts of displacement of the second main surfaces of the pairs of sheets based on at least one of the heights or the inclinations of the upper surfaces of the plurality of first members; and placing the second main surfaces in a displaced manner based on the directions and the amounts of displacement specified.

This method specifies the amount of displacement based on at least one of the measured height or inclination, and can thus place the pairs of sheets in suitable bonding states in accordance with the locations of the first members.

A method of manufacturing a semiconductor device according to a sixteenth aspect of the present disclosure is an embodiment of the method of manufacturing a semiconductor device according to the fourteenth or fifteenth aspect. In the sixteenth aspect, the measuring includes measuring heights of the upper surfaces of the plurality of first members from the first substrate. The placing of the pairs of sheets includes placing the pairs of sheets on the upper surfaces of the plurality of first members, while displacing one of the first bonding sheet or the second bonding sheet of at least one of the pairs of sheets from another one in a direction of inclination of the second main surface based on the heights of the upper surfaces of the plurality of first members.

Even if the plurality of first members have bonding surfaces as different heights, this method can absorb the height differences by adjusting the bonding states between the pairs of sheets.

A method of manufacturing a semiconductor device according to a seventeenth aspect of the present disclosure is an embodiment of the method of manufacturing the semiconductor device according to any one of the fourteenth to sixteenth aspects. In the seventeenth aspect, the measuring includes measuring inclinations of the upper surfaces of the plurality of first members with respect to the first substrate. The placing of the pairs of sheets includes placing the pairs of sheets on the upper surfaces of the plurality of first members, while displacing one of the first bonding sheet or the second bonding sheet of at least one of the pairs of sheets from an other one of the first bonding sheet or the second bonding sheet in a direction of rotation about an axis extending in a direction orthogonal to the second main surfaces based on the inclinations of the upper surfaces of the corresponding one of the plurality of first members.

Even if the bonding surface of one of first members is inclined, this method can absorb the inclination by adjusting the bonding state between the pair of sheets.

A method of manufacturing a semiconductor device according to an eighteenth aspect of the present disclosure includes: preparing a pair of sheets including a first bonding sheet and a second bonding sheet, each being the bonding sheet according to any one of the first to fourth aspects; preparing a first substrate provided with the first member; measuring an inclination of an upper surface of the first member with respect to the first substrate; placing the pair of sheets on the upper surface of the first member, while displacing one of the first bonding sheet or the second bonding sheet from an other one of the first bonding sheet or the second bonding sheet in a direction of rotation about an axis extending in a direction orthogonal to the second main surface based on the inclination; and placing a second substrate that is the second member so as to cover the pair of sheets.

This method can change the inclination of the first main surface of the second bonding sheet with respect to the first main surface of the first bonding sheet by adjusting the positional relationship between the second main surfaces of the first and second bonding sheets. Accordingly, by placing the first and second bonding sheets with a suitable positional relationship in accordance with the inclination of the bonding surface of the first member, the inclination of the first member can be absorbed.

An apparatus for manufacturing a semiconductor device according to a nineteenth aspect of the present disclosure includes: a first mounter that places pairs of sheets each including a first bonding sheet and a second bonding sheet, each being the bonding sheet according to any one of the first to fourth aspects, on upper surfaces of a plurality of first members, each being the first member, placed on a first substrate not to overlap each other in a plan view; a second mounter that places a second substrate that is the second member so as to cover the pairs of sheets; and a measure that measures at least one of heights of the upper surfaces of the plurality of first members from the first substrate or inclinations of the upper surfaces of the plurality of first members with respect to the first substrate. The first mounter places the second main surfaces of at least one of the pairs of sheets in a displaced manner based on at least one of the heights or the inclinations of the upper surfaces of the plurality of first members.

This configuration can change the distance and inclination between the first main surfaces of the first and second bonding sheets by adjusting the positional relationship between the second main surfaces of the first and second bonding sheets. Accordingly, by placing the first and second bonding sheets with a suitable positional relationship in accordance with the position of the first member, the variations in the placement of the first member can be absorbed.

An apparatus for manufacturing a semiconductor device according to a twentieth aspect of the present disclosure includes: a first mounter that places a pair of sheets including a first bonding sheet and a second bonding sheet, each being the bonding sheet according to any one of the first to fourth aspects, on an upper surface of the first member on a first substrate; a second mounter that places a second substrate that is the second member so as to cover the pair of sheets; and a measure that measures an inclination of the upper surface of the first member with respect to the first substrate. The first mounter places the pair of sheets on the upper surface of the first member, while displacing one of the first bonding sheet or the second bonding sheet from another in a direction of rotation about an axis extending in a direction orthogonal to the second main surface based on the inclination.

This configuration can change the inclination of the first main surface of the second bonding sheet with respect to the first main surface of the first bonding sheet by adjusting the positional relationship between the second main surfaces of the first and second bonding sheets. Accordingly, by placing the first and second bonding sheets with a suitable positional relationship in accordance with the inclination of the bonding surface of the first member, the inclination of the first member can be absorbed.

Now, embodiments will be described in detail with reference to the drawings.

Note that the embodiments described below are mere comprehensive or specific examples of the present disclosure. The numerical values, shapes, materials, elements, the placement and connection of the elements, steps, step orders etc. shown in the following embodiments are thus mere examples, and are not intended to limit the scope of the present disclosure. Among the elements in the following embodiments, those not recited in the independent claims will be described as optional.

The drawings are schematic representations and not necessarily drawn strictly to scale. The scales are thus not necessarily the same in the drawings. The same reference signs represent substantially the same configurations in the drawings and redundant description will be omitted or simplified.

In this specification, the terms such as "parallel" or "perpendicular" representing the relationships between the elements, the terms such as "square" or "rectangular" representing the shapes of the elements, and the numerical ranges do not have the exact meaning and include substantially equivalent ranges, such as errors of several percent.

In this specification, the terms "above" and "below" do not represent the upward direction (i.e., in the vertically upward direction) and the downward direction (i.e., in the vertically downward direction) in absolute spatial recognition, but are used as terms defined by a relative positional relationship based on the stacking order of the multilayer structure. In addition, the terms "above" and "below" are applicable not only to the case where two components are spaced apart with another component interposed therebetween, but also to the case where two components are in close contact with each other.

In this specification and the drawings, the x-axis, the y-axis, and the z-axis represent the three axes of a three-dimensional Cartesian coordinate apparatus. In this specification, unless otherwise specified, the positive side of the z-axis is considered to be "above" (i.e., the upper side) and the negative side of the z-axis as "below" (i.e., the lower side).

In this specification, unless otherwise specified, ordinal numbers such as "first" and "second" do not refer to the number or order of the components, but are used to distinguish and avoid confusion between the elements of the same type.

[Embodiment 1]

[1-1. Configuration]

First, an outline of each bonding sheet according to Embodiment 1 will be described with reference to FIGS. 1 and 2. FIG. 1 is a perspective view of bonding sheet 10 according to this embodiment. FIG. 2 is a side view of bonding sheet 10 according to this embodiment.

Bonding sheet 10 according to this embodiment is one of a pair of sheets for bonding a first member and a second member. Note that the first member and the second member are each a semiconductor element, a spacer, a substrate, or any suitable element. The pair of sheets is a bonding sheet pair of two bonding sheets 10.

Each bonding sheet 10 is conductive. With this configuration, bonding sheet 10 can be utilized as a part of electrical connection between the first member and the second member.

Bonding sheet 10 includes main surface 11 as an example of the first main surface to be bonded to the first member or the second member, and main surface 12 as an example of the second main surface at a side opposite to the first main surface. Main surface 12 is inclined with respect to main surface 11. Note that each "main surface" is one of the surfaces of a member (here, bonding sheet 10) with the largest or second largest area. Specifically, main surface 12 is the one of the plurality of surfaces of bonding sheet 10 with the largest area. Main surface 11 is the one of the plurality of surfaces of bonding sheet 10 with the second largest area.

Bonding sheet 10 according to this embodiment has a shape of a flat rectangular parallelepiped (i.e., a rectangular parallelepiped whose height is shorter than its other dimensions) with one of two bases inclined. Specifically, main surface 11 is a square plane in a plan view. Main surface 12 is a plane inclined with respect to main surface 11. Main surface 12 is inclined in a direction (i.e., the x-direction) parallel to one side of main surface 11.

As shown in FIGS. 1 and 2, bonding sheet 10 includes base material 20 and covering layers 21 and 22.

Base material 20 is an example of the metal layer containing metal as a main component. Note that the "main component" means that the component (here, base material 20) accounts for 50% by mass of the materials of the member. Base material 20 is a metal block made of silver (Ag), for example.

As shown in FIG. 2, base material 20 includes main surface 13 that is an example of the third main surface, and main surface 14 that is an example of the fourth main surface at a side opposite to the third main surface. Main surface 13 is a plane parallel to main surface 11. Main surface 14 is a plane parallel to main surface 12.

Base material 20 is a member defining the shape of bonding sheet 10. Base material 20 has a shape in which one of two bases of a flat rectangular parallelepiped is inclined. Specifically, main surface 13 is a square plane in a plan view. Main surface 14 is a plane inclined with respect to main surface 13. Main surface 14 is inclined in a direction (i.e., in the x-direction) parallel to a side of main surface 13.

Base material 20 is formed by a molding technique utilizing a mold, for example. For example, base material 20 in a shape in which main surface 14 is inclined with respect to main surface 13 is obtained by forming a metal material through pressing. Note that the obtainment of base material 20 is not particularly limited. For example, base material 20 may be formed by obliquely grinding the main surface of a metal block in the shape of a rectangular parallelepiped.

Note that main surfaces 13 and 14 may be uneven and are not necessarily the planes parallel to main surface 11 and main surface 12, respectively. Covering layers 21 and 22 may fill the unevenness of main surfaces 13 and 14.

Covering layer 21 is an example of the first covering layer and covers at least a part of main surface 13. Main surface 11 is a part of a surface of covering layer 21. In this embodiment, covering layer 21 covers, with a uniform thickness, entire main surface 13.

Covering layer 22 is an example of the second covering layer and covers at least a part of main surface 14. Main surface 12 is a part of a surface of covering layer 22. In this embodiment, covering layer 22 covers, with a uniform thickness, entire main surface 14.

Covering layers 21 and 22 contain metal as a main component. Specifically, covering layers 21 and 22 contain tin (Sn) or a tin alloy as a main component. The tin alloy contains tin and a metal other than tin. Examples of the other metal include silver (Ag) that is a metal contained in base material 20, and copper (Cu) contained in the first member or the second member. For example, covering layers 21 and 22 are formed by plating main surfaces 13 and 14, respectively.

Note that each side surface of base material 20 may be provided with a covering layer. That is, covering layers 21 and 22 may be integral with each other to cover the entire surfaces of base material 20. Alternatively, bonding sheet 10 may include neither covering layer 21 nor 22. In this case, main surfaces 13 and 14 of base material 20 serve as main surfaces 11 and 12 of bonding sheet 10, respectively.

Thickness T of bonding sheet 10 represents the maximum thickness of bonding sheet 10 as shown in FIG. 2. Specifically, thickness T corresponds to the maximum distance between main surface 11 and main surface 12 in the direction (i.e., the z-direction in FIG. 2) orthogonal to main surface 11. Thickness T is the sum of thickness Tb of the base of bonding sheet 10 and thickness Ts of the inclination of bonding sheet 10. Thickness Ts corresponds to the distance between the upper end and the lower end of main surface 12 in the z-direction and the height of the inclination. In addition, r (unit:°) represents the inclination angle of main surface 12 with respect to main surface 11. For example, r is larger than 0° and smaller than 45°.

Note that the thicknesses of covering layers 21 and 22 are sufficiently smaller than thickness T of bonding sheet 10 and substantially negligible. Specifically, the thicknesses of covering layers 21 and 22 are two or three digits smaller than thickness T of bonding sheet 10. For example, while thickness T falls within a range from 1.0 mm to 10 mm, the thicknesses of covering layers 21 and 22 fall within a range from 0.1 $\mu$m to 10 $\mu$m, for example, 1 $\mu$m.

[1-2. Usage of Bonding Sheet]

Now, usage of bonding sheet 10 will be described.

Two bonding sheets 10 are used in a pair. Specifically, in order to bond a first member and a second member, a pair of sheets (hereinafter referred to as a "bonding sheet pair") including two bonding sheets 10 are used. Two bonding sheets 10 in the bonding sheet pair have the same configuration but are not limited thereto. Two bonding sheets 10 may be different in at least one of the shape, the material, or the size.

Specifically, main surfaces 12 of two bonding sheets 10 are bonded to each other. In addition, main surface 11 of one of two bonding sheets 10 is bonded to the first member. Main surface 11 of the other of two bonding sheets 10 is bonded to the second member.

In accordance with the bonding state of the bonding sheet pair, the heights of the bonding sheet pair and the inclination between two main surfaces 11 of the bonding sheet pair can be adjusted to desired values within a certain range and fixed in the state. This adjustment can absorb the variations in the placement of the first member and the second member to be bonded to two main surfaces 11. In the following, possible bonding states of the bonding sheet pairs will be described with reference to FIGS. 3A to 3C.

[1-2-1. First Bonding State (Normal State)]

FIG. 3A is a side view of bonding sheet pair 30 according to this embodiment in a first bonding state. Bonding sheet pair 30 is an example of the pair of sheets and includes two bonding sheets 10A and 10B. Bonding sheet 10A is an example of the first bonding sheet. Bonding sheet 10B is an example of the second bonding sheet.

Bonding sheets 10A and 10B each have the same configuration as the configuration of bonding sheet 10 shown in FIGS. 1 and 2. Main surfaces 11A and 11B each correspond to main surface 11 that is an example of the first main surface. Main surfaces 12A and 12B each corresponds to main surface 12 that is an example of the second main surface. Note that FIG. 3A and the subsequent figures show none of base material 20, or covering layer 21 or 22.

As shown in FIG. 3A, in the first bonding state, main surfaces 12A and 12B are placed to match completely. Although not shown in FIG. 3A, for example, a semiconductor chip or a spacer is bonded as the first member to main surface 11A of bonding sheet 10A. On the other hand, for example, a substrate or a spacer is bonded as the second member to main surface 11B of bonding sheet 10B.

If main surfaces 12A and 12B match each other completely, thickness T of bonding sheet pair 301 is the sum of thickness T of bonding sheet 10A and thickness Tb of the base of bonding sheet 10B. In addition, main surface 11A to be bonded to the first member and main surface 11B to be bonded to the second member are parallel to each other.

[1-2-2. Second Bonding State (Displaced in Direction of Inclination)]

FIG. 3B is a side view of bonding sheet pair 30 according to this embodiment in a second bonding state.

As shown in FIG. 3B, in the second bonding state, one of main surfaces 12A and 12B is bonded in a displaced manner from the other in the direction of inclination. Here, main surface 12B of bonding sheet 10B slides in a direction (i.e., in the negative direction of the x-axis) of falling with respect to main surface 12A of bonding sheet 10A. In this case, thickness T2 of bonding sheet pair 30 is represented by "T1 - Z1".

T1 represents the thickness of bonding sheet pair 30 in the state shown in FIG. 3A and expressed by "T + Tb (= Ta + 2Tb)". Z1 represents the amount of displacement of bonding sheet 10B in the z-direction. "Z1 = X1 $\times$ tan (r)" holds, where X1 represents the amount of slide in the x-direction from the state shown in FIG. 3A and r represents the inclination angle of each of main surfaces 12A and 12B (unit:°).

In this manner, thickness T2 of bonding sheet pair 30 can change from the state shown in FIG. 3A. Specifically, thickness T2 of bonding sheet pair 30 can be smaller than thickness T1.

Main surface 12B of bonding sheet 10B may slide in a direction (i.e., in the positive direction of the x-axis) of rising with respect to main surface 12A of bonding sheet 10A. In this case, thickness T2 of bonding sheet pair 30 can be larger than thickness T1 shown in FIG. 3A.

If bonding sheet 10A and bonding sheet 10B can be fixed with main surface 12A and main surface 12B in contact with each other even slightly, the thickness of bonding sheet pair 30 is adjustable within a range from 2Tb to 2T. If there is a need to bond main surface 12A and main surface 12B with an area which is half the area of each surface, the thickness of bonding sheet pair 30 is adjustable within a range from T - Ta/2 to 2T - Ta/2.

As long as main surfaces 12A and 12B slide in the direction of inclination (i.e., do not rotate), main surface 11A to be bonded to the first member and main surface 11B to be bonded to the second member are kept in parallel to each other. That is, with the inclination between main surface 11A and main surface 11B kept, only thickness T of bonding sheet pair 30 is adjustable to a desired value.

[1-2-3. Third Bonding State (Displaced in Direction of Rotation)]

FIG. 3C is a side view of bonding sheet pair 30 according to this embodiment in a third bonding state.

As shown in FIG. 3C, in the third bonding state, one of main surfaces 12A and 12B is bonded in a displaced manner from the other in the direction of rotation. The direction of rotation is about an axis extending in the direction orthogonal to main surfaces 12A and 12B. FIG. 3C shows a rotation by 180°, where the rotation angle shown in FIG. 3A is 0°.

The inclination angle of main surface 11A with respect to main surface 11B can be changed by rotating one of bonding sheets 10A and 10B with respect to the other. Specifically, the inclination angle varies within a range from 0° to 2r°. Accordingly, the inclination angle of main surface 11A with respect to main surface 11B can be set and fixed to a desired value by adjusting the rotation angle of one of bonding sheets 10A and 10B.

[1-3. Specification of Amount of Displacement]

Now, how to specify the amount of displacement between bonding sheets 10A and 10B will be described.

The amount of displacement between bonding sheets 10A and 10B depends on the height and inclination of the upper surface of the first member to be bonded to main surface 11A of bonding sheet 10A. In the following, semiconductor chip 40 shown in FIG. 4A is raised as an example of the first member.

FIG. 4A is a plan view of semiconductor chip 40 to be bonded to bonding sheet 10 according to this embodiment. Here, the upper surface of semiconductor chip 40 is in a square shape with a side length of D in a plan view. The upper surface of semiconductor chip 40 is a surface to be bonded to bonding sheet 10.

The height and inclination of the upper surface of semiconductor chip 40 are calculated by measuring the three-dimensional positions of four points P1 to P4 near the edge of the upper surface. The three-dimensional positions are measured, for example, by a ranging apparatus utilizing laser light. Based on the result of measurement at the four points, the height and inclination of the upper surface of semiconductor chip 40 are calculated. Note that the height and inclination are expressed by the maximum height of the upper surface from a predetermined reference plane and the inclination angle of the upper surface with respect to this reference plane. The measurement may be made at three points.

Assume that the result of measurement indicates that the inclination angle of the upper surface is A (unit: °) and the amount of displacement from the reference height is B (unit: mm). Note that examples of the reference height include the height of the upper surface of one of the first members to be mounted on the same substrate, and the mean of the heights of the upper surfaces of a plurality of first members (including semiconductor chip 40) to be mounted on the same substrate.

First, rotation angle θ (unit: °) of bonding sheet 10A for inclining main surface 11A of bonding sheet 10A at the same angle as inclination angle A is calculated. Rotation angle θ corresponds to the amount of displacement in the direction of rotation. Here, the axis of rotation is orthogonal to main surface 11A and in one-to-one correspondence with the axis orthogonal to main surface 12A.

As shown in FIG. 3C, by rotating from 0° to 180°, the inclination angle of main surface 11A changes from 0° to 2r°. Since there is a proportional relationship between the rotation angle and the inclination angle of main surface 11A, θ:A = 180:2r holds. Rotation angle θ is thus represented by following Equation (1).

$$\theta = 90° \times A/r \qquad \qquad ...(1)$$

Note that main surface 11 is, in its plan view, larger than the upper surface of semiconductor chip 40. Although not essential, main surface 11A desirably covers the entire upper surface of semiconductor chip 40, if bonding sheet 10A is rotated at rotation angle θ. This increases the bonding area between semiconductor chip 40 and bonding sheet 10A, improving the heat dissipation and the conductivity.

FIG. 4B is a plan view for illustrating a size relationship between bonding sheet 10A according to this embodiment and semiconductor chip 40. FIG. 4B shows that main surface 11A of bonding sheet 10A is rotated at rotation angle θ (unit: °) about an axis passing through the center of the upper surface of semiconductor chip 40 and orthogonal to this upper surface.

S1 is expressed by following Equation (2), where S1 represents the length of a side of main surface 11A to cover the entire upper surface of semiconductor chip 40 at the time or rotation.

$$S1 = D \times \sin(\theta) + D \times \cos(\theta) \qquad \qquad ...(2)$$

Accordingly, S1 may fall within a range from D to D × √2. If length S1 of a side of main surface 11A is √2 times of length D of a side of the upper surface of semiconductor chip 40, main surface 11A can be bonded to the entire upper surface of semiconductor chip 40 regardless of the value of rotation angle θ.

Next, slide amount X1 (unit: mm) of bonding sheet 10B in the direction of inclination for absorbing the height differences is calculated. Slide amount X1 corresponds to the amount of displacement in the direction of inclination. As shown in FIG. 3B, slide amount X1 is expressed by following Equation (3) using amount Z1 of adjusting the thickness of bonding sheet pair 30.

$$X1 = Z1 \div \tan(r) \qquad \qquad ...(3)$$

Amount X1 of displacement can be calculated utilizing, as amount Z1 of adjusting the thickness, amount B of displacement from the reference height obtained by measurement.

Although not essential, main surface 11B of bonding sheet 10B desirably covers the entire upper surface of semiconductor chip 40 in a top view, if bonding sheet 10B slides with respect to bonding sheet 10A. Specifically, bonding sheets 10A and 10B are desirably placed with no gap interposed in the space directly above the upper surface of semiconductor chip 40. In this manner, when bonding sheet 10B slides with slide amount X1, main surface 11B of bonding sheet 10B needs to have side length S of only D + X1 or more to cover the entire upper surface of semiconductor chip 40. This improves the heat dissipation and the conductivity.

When bonding sheet pair 30 rotates and slides, main surfaces 11A and 11B each have side length S, which is larger than or equal to the sum of side length S1 of main surface 11A and slide amount X1 expressed by Equation (2) to cover the rotation. That is, side length S only needs to satisfy Equation (4).

$$S \geq S1 + X1 = D(\sin(\theta) + \cos(\theta)) + B/\tan(r) \qquad \qquad ...(4)$$

For example, if main surfaces 11A and 11B are each in a rectangular shape in a plan view, the short-side length may be regarded as S. If the upper surface of semiconductor chip 40 is in a rectangular shape in a plan view, the long-side length may be regarded as D.

Depending on the bonding state between bonding sheets 10A and 10B, one or both of bonding sheets 10A and 10B may be in contact with a member such as a substrate. In the following, the thickness (thickness T of bonding sheet 10 as a representative) not to bring bonding sheets 10A and 10B into contact with another member will be described with reference to FIG. 2 mainly.

Thickness Ts of the inclination of bonding sheet 10 is expressed by following Equation (5) using side length S of main surface 11 and inclination angle r of main surface 12.

$$Ts = \tan(r) \times S \qquad \qquad \ldots (5)$$

If bonding sheet 10 is placed in a rotated manner at rotation angle θ, following Equation (6) is available from Equations (2) and (5).

$$Ts = \tan(r) \times D(\sin(\theta) + \cos(\theta)) \qquad \qquad \ldots (6)$$

If bonding sheet 10 is rotated at rotation angle θ, the lower end of bonding sheet 10B desirably fails to protrude downward beyond main surface 11A of bonding sheet 10A. Protruding downward, the lower end of bonding sheet 10B may come into contact with another member. Thickness Tb of the base of bonding sheet 10 only needs to satisfy following Expression (7) so that the lower end of bonding sheet 10B does not protrude downward beyond main surface 11A of bonding sheet 10A.

[Math. 1]

$$(7) \qquad Tb \geqq \frac{S \times \sqrt{2 + \tan^2(r)} \times \sin 2(r) - \dfrac{S}{\cos(r)}}{2 \times \sin(r)}$$

As shown in FIG. 3B, if bonding sheet 10B slides with respect to bonding sheet 10A in a direction of falling with slide amount X1, thickness Tb of the base of bonding sheet 10 needs to include amount B of displacement from the reference height. From the foregoing, thickness T of bonding sheet 10 needs to be the sum of Ts expressed by Equation (6), the minimum Tb expressed by Expression (7), and amount B of displacement from the reference height. Accordingly, thickness T of bonding sheet 10 only needs to fall within the range expressed by following Expression (8).

[Math. 2]

$$(8) \, T \geqq \tan(r) \times D\left(\sin\left(\frac{90° \times A}{r}\right) + \cos\left(\frac{90° \times A}{r}\right)\right) + \frac{S \times \sqrt{2 + \tan^2(r)} \times \sin 2(r) - \dfrac{S}{\cos(r)}}{2 \times \sin(r)} + B$$

Excessively large thickness T of bonding sheet pair 30 deteriorates the heat dissipation and the conductivity. An increase in thickness T also leads to an increase in the size of the semiconductor device. In this embodiment, for example, thickness T is 10 mm and may be 7 mm. The thickness is however not limited thereto. Note that thickness Tb and thickness Ts may be equal to each other, or one of them may be larger than the other.

Inclination angle r (unit: °) of main surface 12 is larger than 0° and smaller than 45°. Inclination angle r may be larger than 1° and smaller than or equal to 20°. As clear from Expression (8) described above, the minimum value of thickness T of bonding sheet 10 depends on the value of inclination angle r.

FIG. 5 shows a relationship between inclination angle r of main surface 12 of bonding sheet 10 and thickness T of bonding sheet 10. As shown in FIG. 5, the horizontal axis represents inclination angle r (unit: °), and the vertical axis represents thickness T (unit: mm). In FIG. 5, the values of T are plotted, which are calculated for the inclination angle at degrees within a range from 1° to 17° based on Expression (8). The calculation is made where inclination A of semiconductor chip 40 is 1°, amount B of displacement from the reference height is 0.1 mm, and side length D of the upper surface of semiconductor chip 40 is 5 mm.

As shown in FIG. 5, within a range from 2° to 17° of inclination angle r, thickness T of bonding sheet 10 can be about 3 mm or smaller. Within a range from 4° to 15° of inclination angle r, thickness T of bonding sheet 10 can be about 2 mm or smaller. Within a range from 7° to 8° of inclination angle r, thickness T of bonding sheet 10 is the minimum. Smaller thickness T of bonding sheet 10 can further improve the heat dissipation and the conductivity and contribute to the downsizing of the semiconductor device.

[Embodiment 2]

Now, Embodiment 2 will be described.

In Embodiment 2, a semiconductor device will be described which includes the bonding sheet pair described in Embodiment 1. In the following, the differences from Embodiment 1 will be described mainly, and the description of the common matters will be omitted or simplified.

[2-1. Configuration]

First, a configuration of the semiconductor device according to Embodiment 2 will be described with reference to FIG. 6. FIG. 6 is a cross-sectional view of semiconductor device 100 according to this embodiment.

As shown in FIG. 6, semiconductor device 100 includes lower substrate 110, upper substrate 120, bonding members 131, 132, and 133, semiconductor chips 141, 142, and 143, bonding sheet pairs 151, 152, and 153, and sealing member 160. In this embodiment, the semiconductor chips and the bonding sheet pairs are in one-to-one correspondence.

Lower substrate 110 is an example of the first substrate. Lower substrate 110 includes heat sink 112, insulating layer 114, and electrodes 116, 117, and 118.

Heat sink 112 is a flat plate containing, as a main component, a material such as metal with a high thermal conductivity. Heat sink 112 is a metal plate made of copper (Cu), for example. Heat sink 112 is provided mainly to dissipate the heat generated by semiconductor chips 141, 142, and 143 into the air or another member.

Insulating layer 114 contains an electrically insulating material as a main component. Insulating layer 114 contains silicon nitride, alumina, aluminum nitride, or any other suitable component. Insulating layer 114 is provided to electrically insulate electrodes 116, 117, and 118 from heat sink 112. Insulating layer 114 is larger than heat sink 112 and covers the entire upper surface of heat sink 112. The configuration is however not limited thereto. Insulating layer 114 may be in the same size as heat sink 112, or smaller than heat sink 112. Insulating layer 114 may be provided as islands only in the areas provided with electrodes 116, 117, and 118. That is, insulating layer 114 only needs to ensure the electrical isolation of electrodes 116, 117, and 118 from heat sink 112. There is no need for insulating layer 114 to cover the entire upper surface of heat sink 112.

Electrodes 116, 117, and 118 are in one-to-one correspondence to semiconductor chips 141, 142, and 143. Note that electrodes 116, 117, and 118 may be electrically connected to each other. Electrodes 116, 117, and 118 contain a conductive material as a main component. For example, electrodes 116, 117, and 118 are made of metal such as copper (Cu).

Upper substrate 120 is an example of the second substrate in parallel to the first substrate. Note that the first substrate and the second substrate are placed in parallel means that one main surface of the first substrate and one main surface of the second substrate are parallel to each other. For example, two main surfaces, which face each other, of the first substrate and the second substrate are parallel.

In this embodiment, upper substrate 120 is an example of the second member to which bonding sheet pairs 151, 152, and 153 are bonded. As shown in FIG. 6, upper substrate 120 includes heat sink 122, insulating layer 124, and electrode 126.

Heat sink 122 is a flat plate containing, as a main component, a material such as metal with a high thermal conductivity. Heat sink 122 is a metal plate made of copper (Cu), for example. Heat sink 122 is provided mainly to dissipate the generated by semiconductor chips 141, 142, and 143 into the air or another member.

Insulating layer 124 contains an electrically insulating material as a main component. Insulating layer 124 contains silicon nitride, alumina, aluminum nitride, or any other suitable component. Insulating layer 124 is provided to electrically insulate electrode 126 from heat sink 122. Insulating layer 124 is larger than heat sink 122 and covers the entire lower surface of heat sink 122. The configuration is however not limited thereto. Insulating layer 124 may be in the same size as heat sink 122, or smaller than heat sink 122. That is, electrode 126 only needs to ensure the electrical isolation of electrode 126 from heat sink 122 and there is no need for insulating layer 124 to cover the entire lower surface of heat sink 122.

Electrode 126 is a single electrode in common among semiconductor chips 141, 142, and 143. Alternatively, in place of electrode 126, electrodes in one-to-one correspondence to semiconductor chips 141, 142, and 143 may be provided like electrodes 116, 117, and 118 on lower substrate 110. Electrode 126 contains a conductive material as a main component. For example, electrode 126 is made of metal such as copper (Cu).

Lower substrate 110 and upper substrate 120 are direct bonded copper (DBC) substrates, for example. Lower substrate 110 and upper substrate 120 are obtained by forming a copper film on both sides of insulating layers 114 and 124, respectively, which are plates made of a ceramic material, and then patterning the copper film as necessary. Note that the configurations of lower substrate 110 and upper substrate 120 are not particularly limited. For example, heat sink 112 or 122, or electrode 116, 117, 118, or 126 may have a single-layer structure or a multi-layer structure of metal or a metal alloy.

Insulating layer 114 or 124 may have a single-layer structure or a multi-layer structure of an insulating film. Lower substrate 110 and upper substrate 120 may each include only a heat sink made of metal.

Bonding members 131, 132, and 133 are provided in different regions of the upper surface of lower substrate 110. Bonding members 131, 132, and 133 are in one-to-one correspondence to semiconductor chips 141, 142, and 143. Specifically, bonding member 131 bonds the lower surface of semiconductor chip 141 and electrode 116. Bonding member 132 bonds the lower surface of semiconductor chip 142 and electrode 117. Bonding member 133 bonds the lower surface of semiconductor chip 143 and electrode 118.

Bonding members 131, 132, and 133 contain a conductive material as a main component. For example, bonding members 131, 132, and 133 are in the shape of a flat rectangular parallelepiped made of silver (Ag) with tin (Sn) coated (e.g., plated) on the surface. Alternatively, bonding members 131, 132, and 133 may be Ag sintering paste. The Ag sintering paste is a sintering material containing nano- or micro-sized Ag particles.

Semiconductor chips 141, 142, and 143 are each an example of the first member that is a semiconductor element. Semiconductor chips 141, 142, and 143 are placed between lower substrate 110 and upper substrate 120 not to overlap each other in a plan view of lower substrate 110. In this embodiment, semiconductor chips 141, 142, and 143 are each an element including two electrodes.

FIG. 7 includes (a) a top view, (b) a side view, and (c) a bottom view showing a configuration of each of semiconductor chips 141, 142, and 143 of semiconductor device 100 according to this embodiment. Semiconductor chips 141, 142, and 143 are specific examples of semiconductor chip 40 described in Embodiment 1 and have the same configuration. In the following, semiconductor chip 141 will be described as a representative example.

Semiconductor chip 141 is a semiconductor element, such as a Schottky barrier diode (SBD) or a freewheeling diode (FWD), including two external electrodes. As shown in FIG. 7, semiconductor chip 141 includes chip body 145, lower electrode 146, and upper electrode 147.

Chip body 145 is the body of an element formed on a substrate containing, as a main component, silicon carbide (SiC), silicon (Si), gallium nitride (GaN), gallium oxide (GaO), diamond, or any other suitable component. Chip body 145 is in the shape of a flat rectangular parallelepiped. The size of chip body 145 is not particularly limited. Each side length falls within a range from 1 mm to 20 mm. The thickness falls within a range from 0.01 mm to 0.5 mm.

Lower electrode 146 is provided on the lower surface of chip body 145. Lower electrode 146 has a single-layer structure or a multi-layer structure of metal or a metal alloy. For example, lower electrode 146 has a multilayer structure of titanium (Ti), nickel (Ni), and silver (Ag) stacked in this order from chip body 145, but is not limited thereto. For example, the outermost layer (i.e., the lowermost layer) of lower electrode 146 may be made of gold (Au).

Upper electrode 147 is provided on the upper surface of chip body 145. Upper electrode 147 has a single-layer structure or a multi-layer structure of metal or a metal alloy. For example, upper electrode 147 may have a multilayer structure of titanium (Ti), nickel (Ni), and silver (Ag) stacked in this order from chip body 145, but is not limited thereto. For example, the outermost layer (i.e., the uppermost surface) of upper electrode 147 may be made of gold (Au).

If semiconductor chip 141 is a diode, one of lower electrode 146 or upper electrode 147 is an anode electrode and the other is a cathode electrode. Lower electrode 146 and upper electrode 147 are provided to cover almost the entire lower surface and almost the entire upper surface of chip body 145, respectively. The upper surface of upper electrode 147 is the upper surface of semiconductor chip 141 and is connected to the first main surface (i.e., main surface 11A) of the corresponding one of bonding sheet pair 30 (i.e., bonding sheet pair 151, 152, or 153).

Bonding sheet pairs 151, 152, and 153 are each bonding sheet pair 30 described in Embodiment 1. As shown in FIG. 6, bonding sheet pair 151 includes bonding sheets 151A and 151B. Bonding sheet pair 152 includes bonding sheets 152A and 152B. Bonding sheet pair 153 includes bonding sheets 153A and 153B. Bonding sheets 151A, 152A, and 153A are each an example of the first bonding sheet and corresponds to bonding sheet 10A shown in FIGS. 3A to 3C. Bonding sheets 151B, 152B, and 153B are each an example of the second bonding sheet and corresponds to bonding sheet 10B shown in FIGS. 3A to 3C.

In this embodiment, bonding sheet pairs 151, 152, and 153 are in one-to-one correspondence to semiconductor chips 141, 142, and 143. The first main surface (i.e., main surface 11A) of bonding sheet 151A is bonded to semiconductor chip 141 (specifically, upper electrode 147). Semiconductor chip 142 (specifically, upper electrode 147) is bonded to the first main surface (i.e., main surface 11A) of bonding sheet 152A. Semiconductor chip 143 (specifically, upper electrode 147) is bonded to the first main surface (i.e., main surface 11A) of bonding sheet 153A. The first main surfaces (i.e., main surfaces 11B) of bonding sheets 151B, 152B, and 153B are bonded to upper substrate 120 (specifically, electrode 126). Specific bonding states of bonding sheet pairs 151, 152, and 153 will be described later.

Sealing member 160 is a resin member that seals semiconductor chips 141, 142, and 143. Sealing member 160 is made of an insulating resin material such as epoxy. Sealing member 160 is provided to protect semiconductor chips 141, 142, and 143 from moisture and air.

[2-2. Example of Absorbing Height Differences]

In this embodiment, the upper surfaces of semiconductor chips 141, 142, and 143 are at different heights. Note that the "heights" here are each the distance from the upper surface of lower substrate 110 (specifically, the upper surfaces of electrodes 116, 117, and 118). As shown in FIG. 6, the upper surface of semiconductor chip 141 is lower than the upper surface of semiconductor chip 142 and higher than the upper surface of semiconductor chip 143.

In semiconductor device 100, the height differences of the upper surfaces of semiconductor chips 141, 142, and 143 can be absorbed by adjusting the bonding states of bonding sheet pairs 151, 152, and 153. Specifically, the bonding states of bonding sheet pairs 151, 152, and 153 are determined based on the result of measuring the heights of the upper surfaces of semiconductor chips 141, 142, and 143 so that the first main surfaces (i.e., main surfaces 11B) of bonding sheets 151B, 152B, and 153B are at the same height.

FIG. 8 is a plan view showing bonding states of a plurality of bonding sheet pairs 151, 152, and 153 of semiconductor device 100 according to this embodiment. In FIG. 8, the broken arrows each indicate the direction of inclination of a bonding sheet (i.e., lower bonding sheet 151A, 152A, or 153A) to be bonded to the first member (i.e., semiconductor chip 141, 142, or 143). The solid arrows each indicate the direction of inclination of a bonding sheet (i.e., upper bonding sheet 151B, 152B, or 153B) to be bonded to the second member (i.e., upper substrate 120). In the direction of inclination, each bonding sheet has a decreasing thickness in the positive direction (i.e., in the negative direction of the x-axis in the example of FIG. 2).

As shown in FIGS. 6 and 8, in bonding sheet pair 151, bonding sheet 151A and bonding sheet 151B are placed to match each other completely in a top view (i.e., the bonding state shown in FIG. 3A).

As shown in FIGS. 6 and 8, in bonding sheet pair 152, bonding sheet 152B slides from bonding sheet 152A in the direction of falling (i.e., the bonding state shown in FIG. 3B). The upper surface of semiconductor chip 142 is located higher than the upper surface of semiconductor chip 141. The height differences are thus absorbed by setting the thickness of bonding sheet pair 152 smaller than the thickness of bonding sheet pair 151.

As shown in FIGS. 6 and 8, in bonding sheet pair 153, bonding sheet 153B slides from bonding sheet 153A in the direction of rising. The upper surface of semiconductor chip 143 is located lower than the upper surface of semiconductor chip 141. The height differences are absorbed by setting the thickness of bonding sheet pair 153 smaller than the thickness of bonding sheet pair 151.

In bonding sheet pair 151, main surface 11A of lower bonding sheet 151A and semiconductor chip 141 are placed so that the centers thereof match each other. On the other hand, in bonding sheet pairs 152 and 153, main surfaces 11A of lower bonding sheets 152A and 153A and semiconductor chip 141 are placed so that the centers thereof do not match each other. In other words, lower bonding sheets 151A, 152A, and 153A are bonded to corresponding semiconductor chips 141, 142, and 143 at different points. Bonding at the different points reduces the gaps between the bonding sheet pairs in the spaces directly above semiconductor chips 141, 142, and 143. This configuration can efficiently transfer the heat generated by semiconductor chips 141, 142, and 143 to upper substrate 120, improving the heat dissipation. The configuration also increases the mechanical bonding strength and the conductivity.

As described above, in semiconductor device 100 according to this embodiment, the bonding states of bonding sheet pairs 151, 152, and 153 are adjusted based on the heights of the upper surfaces of corresponding semiconductor chips 141, 142, and 143. This adjustment absorbs the height differences of the upper surfaces of semiconductor chips 141, 142, and 143. At this time, no gaps are left between the bonding sheet pairs in the spaces directly above semiconductor chips 141, 142, and 143. This configuration can strengthen the thermal, electrical, and mechanical bonding between the semiconductor chips and upper substrate 120. As a result, the heat dissipation, the conductivity, and the mechanical bonding strength improve.

[2-3. Example of Absorbing Inclinations]

Now, an example of absorbing the inclinations of bonding sheet pairs 151, 152, and 153 will be described with reference to FIGS. 9 and 10.

FIG. 9 is a cross-sectional view showing another example of the semiconductor device according to this embodiment. Semiconductor device 101 shown in FIG. 9 includes the same elements as semiconductor device 100 shown in FIG. 6. The orientations and positions of semiconductor chips 142 and 143 and the bonding states of bonding sheet pairs 152 and 153 are different. In the following, the differences from semiconductor device 100 will be described mainly, and the description of the common matters will be omitted or simplified.

In FIG. 9, the upper surfaces of semiconductor chips 142 and 143 are inclined with respect to the upper surfaces of semiconductor chip 141. The upper surface of semiconductor chip 143 is inclined at a larger inclination angle than that of the upper surface of semiconductor chip 142.

FIG. 10 is a plan view showing bonding states of a plurality of bonding sheet pairs 151, 152, and 153 of semiconductor device 100 according to this embodiment. In FIG. 10, the broken arrows each indicate the direction of inclination of a bonding sheet (i.e., lower bonding sheet 151A, 152A, or 153A) to be bonded to the first member (i.e., semiconductor chip 141, 142, or 143). The solid arrows each indicate the direction of inclination of a bonding sheet (i.e., upper bonding sheet 151B, 152B, or 153B) to be bonded to the second member (i.e., upper substrate 120). In the direction of inclination, each bonding sheet has a decreasing thickness in the positive direction (i.e., in the negative direction of the x-axis in the example of FIG. 2).

As shown in FIGS. 9 and 10, in bonding sheet pair 152, one of bonding sheets 152A and 152B is located in a rotated manner from the other at rotation angle θ. Rotation angle θ is determined based on the inclination angle of the upper surface of semiconductor chip 142. Accordingly, the first main surface (i.e., main surface 11A) of bonding sheet 152A is inclined with respect to the first main surface (i.e., main surface 11B) of bonding sheet 152B. This can absorb the inclination of the upper surface of semiconductor chip 142. That is, the first main surface (i.e., main surface 11B) of bonding sheet 152B can be flush with the first main surface (i.e., main surface 11B) of bonding sheet 151B.

As shown in FIGS. 9 and 10, in bonding sheet pair 153, one of bonding sheets 153A and 153B is located in a rotated manner from the other at an angle of 180°(i.e., the bonding state shown in FIG. 3C). While an example has been described here where the rotation angle is 180°, the angle may be smaller than 180°. Accordingly, the first main surface (i.e., main surface 11A) of bonding sheet 153A is inclined with respect to the first main surface (i.e., main surface 11B) of bonding sheet 153B. This can absorb the inclination of the upper surface of semiconductor chip 143. That is, the first main surface (i.e., main surface 11B) of bonding sheet 153B can be flush with the first main surface (i.e., main surface 11B) of bonding sheet 151B.

In a rotated state as well, no gaps are left between the bonding sheet pairs in the spaces directly above semiconductor chips 142 and 143. Specifically, the points of boding between main surfaces 11A of bonding sheets 152A and 153A and semiconductor chips 142 and 143 are adjusted. The adjustment can efficiently transfer the heat generated by semiconductor chips 141, 142, and 143 to upper substrate 120, improving the heat dissipation. The adjustment also increases the mechanical bonding strength and the conductivity.

As described above, in semiconductor device 101 according to this embodiment, the bonding states of bonding sheet pairs 151, 152, and 153 are adjusted based on the inclinations of the upper surfaces of corresponding semiconductor chips 141, 142, and 143. This adjustment absorbs the inclinations of the upper surfaces of semiconductor chips 141, 142, and 143. At this time, no gaps are left between the bonding sheet pairs in the spaces directly above semiconductor chips 141, 142, and 143. This configuration can strengthen the thermal, electrical, and mechanical bonding between the semiconductor chips and upper substrate 120. As a result, the heat dissipation, the conductivity, and the mechanical bonding strength improve.

[2-4. Manufacturing Method]

Now, a method of manufacturing semiconductor device 100 will be described with reference to FIGS. 11A to 11E.

FIGS. 11A to 11E are cross-sectional views showing steps of the method of manufacturing semiconductor device 100 according to this embodiment.

First, as shown in FIG. 11A, lower substrate 110 is prepared. For example, lower substrate 110 is obtained by forming a metal film made of copper, for example, on each of the upper and lower surfaces of insulating layer 114 and then patterning the metal film as necessary. Note that the obtainment of lower substrate 110 is not limited thereto. Alternatively, lower substrate 110 formed in advance may be used.

Next, as shown in FIG. 11B, bonding members 131, 132, and 133 are placed on the upper surfaces of electrodes 116, 117, and 118, respectively, on lower substrate 110. For example, bonding members 131, 132, and 133 are each a block member (e.g., a Sn-coated bonding material) of silver (Ag) with the surface coated with tin (Sn), or Ag sintering paste.

Then, as shown in FIG. 11C, semiconductor chips 141, 142, and 143 are placed on the upper surfaces of bonding members 131, 132, and 133, respectively. After placing semiconductor chips 141, 142, and 143, bonding members 131, 132, and 133 are bonded by heat treatment. The heat treatment is the process according to the material of bonding members 131, 132, and 133. For example, if bonding members 131, 132, and 133 are made of a Sn-coated bonding material, reflow treatment through formic acid reduction or hydrogen reduction is performed as the heat treatment. If bonding members 131, 132, and 133 are Ag sintering paste, reflow or annealing in a nitrogen atmosphere is performed as the heat treatment. Accordingly, the lower surfaces of bonding members 131, 132, and 133 are bonded to electrodes 116, 117, and 118, respectively. The upper surfaces of bonding members 131, 132, and 133 are bonded to semiconductor chips 141, 142, and 143, respectively.

After that, as shown in FIG. 11D, bonding sheet pairs 151, 152, and 153 are placed on the upper surfaces of semiconductor chips 141, 142, and 143, respectively. Although not shown in the figure, before placing the bonding sheet pairs, at least one of the heights or the inclinations of the upper surfaces of semiconductor chips 141, 142, and 143 are measured. Based on the results of measurement, the directions of displacement and the amounts of displacement between the second main surfaces (i.e., main surfaces 12A and 12B) of the bonding sheet pairs corresponding to the semiconductor chips are specified. Specifically, in order to specify the directions of displacement and the amounts of displacement between the second main surfaces, the three-dimensional positions (i.e., x-, y-, and z-coordinates) and rotation angles (θ) between the two bonding sheets are calculated. Alternatively, the directions of displacement and the amounts of displacement between the second main surfaces themselves may be calculated. Based on the calculated three-dimensional positions and rotation angles, lower bonding sheets 151A, 152A, and 153A and upper bonding sheets 151B, 152B, and 153B are placed. Accordingly, in accordance with the conditions of the heights and the inclinations of the upper surfaces of the semiconductor chips, the second main surfaces of the corresponding bonding sheet pairs are placed in a displaced manner. As indicated by the broken line in FIG. 11D, the upper surfaces (i.e., main surfaces 11B) of bonding sheet pairs 151, 152, and 153 are flush with each other.

Next, as shown in FIG. 11E, upper substrate 120 is placed to cover the upper surfaces of bonding sheet pairs 151, 152, and 153. After placing upper substrate 120, bonding sheet pairs 151, 152, and 153 are bonded by heat treatment. For example, if the bonding sheets of bonding sheet pairs 151, 152, and 153 are made of a Sn-coated bonding material, reflow treatment through formic acid reduction or hydrogen reduction is performed as the heat treatment. Accordingly, the first main surface (i.e., main surface 11A) of the lower, first bonding sheet in each bonding sheet pair is bonded to the corresponding semiconductor chip. The second main surface (i.e., main surface 11B) of the upper, second bonding sheet of each bonding sheet pair is boded to upper substrate 120. The second main surfaces (i.e., main surfaces 12A and 12B) of each bonding sheet pair are bonded. The positional relationship between the first bonding sheet and the second bonding sheet after the bonding is fixed and kept stable. At each bonding point, an alloy of copper (Cu) and tin (Sn) or an alloy of silver (Ag) and tin (Sn) is formed, providing excellent thermal, mechanical, and electrical bonding.

After that, the configuration shown in FIG. 11E is sealed with sealing member 160 such as a resin. Semiconductor device 100 shown in FIG. 6 or semiconductor device 101 shown in FIG. 17 is then manufactured.

As described above, the bonding between the bonding sheets and the bonding sheets and other members can be strengthen thermally, electrically, and mechanically utilizing a covering layer of Sn or any other suitable material on the surface of the bonding sheets. This can improve the heat dissipation, the conductivity, and the mechanical bonding strength of semiconductor device 100 or 101. For example, in view of the heat dissipation, heat resistance up to 250°C can be achieved.

[Embodiment 3]

Now, Embodiment 3 will be described.

Embodiment 3 is different from Embodiment 2 mainly in the configuration of the bonding sheets. In the following, the differences from Embodiment 2 will be described mainly, and the description of the common matters will be omitted or simplified.

[3-1. Configuration]

First, a configuration of a semiconductor device according to Embodiment 3 will be described with reference to FIG. 12.

FIG. 12 is a cross-sectional view of semiconductor device 200 according to this embodiment. As shown in FIG. 12, semiconductor device 200 includes bonding sheet pairs 251, 252, and 253 in place of bonding sheet pairs 151, 152, and 153 as compared to semiconductor device 100 shown in FIG. 6. In addition, semiconductor device 200 includes bonding layers 271, 272, 273, 274, 275, 276, 277, 278, and 279.

As shown in FIG. 12, bonding sheet pair 251 includes bonding sheets 251A and 251B. Bonding sheet pair 252 includes bonding sheets 252A and 252B. Bonding sheet pair 253 includes bonding sheets 253A and 253B. Bonding sheets 251A, 252A, and 253A are each an example of the first bonding sheet with a configuration excluding covering layers 21 and 22 from bonding sheet 10 shown in FIG. 2. Bonding sheets 251B, 252B, and 253B are each an example of the second bonding sheet with a configuration excluding covering layers 21 and 22 from bonding sheet 10 shown in FIG. 2. For example, bonding sheets 251A, 251B, 252A, 252B, 253A, and 253B are each a metal block member made of silver (Ag).

Bonding layers 271, 272, 273, 274, 275, 276, 277, 278, and 279 are each a member that bonds two adjacent members. Bonding layers 271, 272, 273, 274, 275, 276, 277, 278, and 279 are each conductive. For example, bonding layers 271, 272, 273, 274, 275, 276, 277, 278, and 279 are each a sintering material made of silver (Ag).

Bonding layer 271 bonds the upper surface of semiconductor chip 141 and the first main surface (i.e., main surface 11A) of bonding sheet 251A of bonding sheet pair 251. Bonding layer 272 bonds the upper surface of semiconductor chip 142 and the first main surface (i.e., main surface 11A) of bonding sheet 252A of bonding sheet pair 252. Bonding layer 273 bonds the upper surface of semiconductor chip 143 and the first main surface (i.e., main surface 11A) of bonding sheet 253A of bonding sheet pair 253.

Bonding layer 274 bonds the second main surface (i.e., main surface 12A) of bonding sheet 251A of bonding sheet pair 251 and the second main surface (i.e., main surface 12B) of bonding sheet 251B. Bonding layer 275 bonds the second main surface (i.e., main surface 12A) of bonding sheet 252A of bonding sheet pair 252 and the second main surface (i.e., main surface 12B) of bonding sheet 252B. Bonding layer 276 bonds the second main surface (i.e., main surface 12A) of bonding sheet 253A of bonding sheet pair 253 and second main surface (i.e., main surface 12B) of bonding sheet 253B.

Bonding layer 277 bonds the first main surface (i.e., main surface 11B) of bonding sheet 251B of bonding sheet pair 251 and electrode 126 of upper substrate 120. Bonding layer 278 bonds the first main surface (i.e., main surface 11B) of bonding sheet 252B of bonding sheet pair 252 and electrode 126 of upper substrate 120. Bonding layer 279 bonds the first main surface (i.e., main surface 11B) of bonding sheet 253B of bonding sheet pair 253 and electrode 126 of upper substrate 120.

As in semiconductor device 100 shown in FIG. 6, in semiconductor device 200 shown in FIG. 12, bonding sheet pairs 251, 252, and 253 are placed in different bonding states so as to absorb the height differences of the upper surfaces of semiconductor chips 141, 142, and 143. Bonding layers 274, 275, and 276 are interposed between bonding sheet pairs 251, 252, and 253, respectively. Otherwise, the bonding states of bonding sheet pairs 251, 252, and 253 are the same as those of bonding sheet pairs 151, 152, and 153 shown in FIGS. 6 and 8.

FIG. 13 shows an example of absorbing the inclinations of the upper surfaces of semiconductor chips 141, 142, and 143. FIG. 13 is a cross-sectional view showing another example of the semiconductor device according to this embodiment. Semiconductor device 201 shown in FIG. 13 have the same elements as semiconductor device 200 shown in FIG. 12.

As in semiconductor device 101 shown in FIG. 9, in semiconductor device 201 shown in FIG. 13, bonding sheet pairs 251, 252, and 253 are placed in different bonding states to absorb the inclinations of the upper surfaces of semiconductor chips 141, 142, and 143. Bonding layer 274, 275, and 276 are interposed between bonding sheet pair 251, 252, and 253, respectively. Otherwise, the bonding states are the same as those of bonding sheet pairs 151, 152, and 153 shown in FIGS. 9 and 10.

[3-2. Manufacturing Method]

Now, a method of manufacturing semiconductor device 200 will be described with reference to FIGS. 14A to 14F.

FIGS. 14A to 14F are cross-sectional views showing steps of the method of manufacturing semiconductor device 200 according to this embodiment. In the method of manufacturing semiconductor device 200, the processes from the preparation of lower substrate 110 through the placement of semiconductor chips 141, 142, and 143 to the bonding of bonding members 131, 132, and 133 are the same as in Embodiment 2 and as shown in FIGS. 11A to 11C.

After bonding semiconductor chips 141, 142, and 143 and bonding members 131, 132, and 133, as shown in FIG. 14A, bonding layers 271, 272, and 273 are placed on the upper surfaces of semiconductor chips 141, 142, and 143, respectively. Bonding layers 271, 272, and 273 are made of Ag sintering paste, for example. For example, the Ag sintering paste is applied to cover the entire upper surfaces of semiconductor chips 141, 142, and 143.

Next, as shown in FIG. 14B, bonding sheets 251A, 252A, and 253A are placed on the upper surfaces of bonding layers 271, 272, and 273, respectively. Although not shown in the figure, before placing the bonding sheets, at least one of the heights or the inclinations of the upper surfaces of semiconductor chips 141, 142, and 143 are measured. Based on the results of measurement, the directions of displacement and the amounts of displacement between the second main surfaces (i.e., main surfaces 12A and 12B) of the bonding sheet pairs corresponding to the semiconductor chips are specified. Specifically, in order to specify the directions of displacement and the amounts of displacement between the second main surfaces, the three-dimensional positions (i.e., x-, y-, and z-coordinates) and rotation angles ($\theta$) between the two bonding sheets are calculated. Alternatively, the directions of displacement and the amounts of displacement between the second main surfaces themselves may be calculated. Based on the calculated three-dimensional positions and rotation angles, lower bonding sheets 251A, 252A, and 253A are placed sequentially.

Then, as shown in FIG. 14C, bonding layers 274, 275, and 276 are placed on the second main surfaces (i.e., main surfaces 12A) of bonding sheets 251A, 252A, and 253A, respectively. Bonding layers 274, 275, and 276 are made of Ag sintering paste, for example. For example, the Ag sintering paste is applied to cover the entire second main surfaces (i.e., main surfaces 12A) of bonding sheets 251A, 252A, and 253A.

After that, as shown in FIG. 14D, bonding sheets 251B, 252B, and 253B are placed on the upper surfaces of bonding layers 274, 275, and 276, respectively. The locations (i.e., the three-dimensional positions and the rotation angles) of bonding sheets 251B, 252B, and 253B are determined based on the results of measuring at least one of the heights or the inclinations of the upper surfaces of semiconductor chips 141, 142, and 143. In accordance with the conditions of the heights and the inclinations of the upper surfaces of the semiconductor chips, the second main surfaces of the corresponding bonding sheet pairs are placed in a displaced manner. The upper surfaces (i.e., main surfaces 11B) of bonding sheet pairs 251, 252, and 253 are thus flush with each other.

Next, as shown in FIG. 14E, bonding layers 277, 278, and 279 are placed on the first main surfaces (i.e., main surface 11B) of bonding sheets 251B, 252B, and 253B, respectively. Bonding layers 277, 278, and 279 are made of Ag sintering paste, for example. For example, the Ag sintering paste is applied to cover the entire first main surfaces (i.e., main surfaces 11B) of bonding sheets 251B, 252B, and 253B.

Then, as shown in FIG. 14F, upper substrate 120 is placed to cover the upper surfaces of bonding sheet pairs 251, 252, and 253. After placing upper substrate 120, bonding sheet pairs 251, 252, and 253 are bonded by heat treatment. In this embodiment, reflow or annealing in a nitrogen atmosphere is performed as the heat treatment. Accordingly, the first main surface (i.e., main surface 11A) of the lower, first bonding sheet is bonded to the corresponding semiconductor chip. The second main surface (i.e., main surface 11B) of the upper, second bonding sheet of each bonding sheet pair is boded to upper substrate 120. The second main surfaces (i.e., main surfaces 12A and 12B) of each bonding sheet pair are bonded. At this time, bonding layers 271, 272, 273, 274, 275, 276, 277, 278, and 279 are interposed. The positional relationship between the first bonding sheet and the second bonding sheet after the bonding is fixed and kept stable. At each bonding point, a sintered layer of silver (Ag) is formed, providing excellent thermal, mechanical, and electrical bonding.

After that, the configuration shown in FIG. 14F is sealed with sealing member 160 such as a resin. Semiconductor device 200 shown in FIG. 12 or semiconductor device 201 shown in FIG. 13 is then manufactured.

As described above, even if the surfaces of the bonding sheets are not coated with tin (Sn), the bonding between the bonding sheets and the bonding sheets and other members can be strengthen thermally, electrically, and mechanically utilizing a bonding layer of Ag sintering paste, for example. As a result, the heat dissipation, the conductivity and the mechanical bonding strength improve.

[Embodiment 4]

Now, Embodiment 4 will be described.

Embodiment 4 is different from Embodiment 2 mainly in the configuration of the semiconductor chips. In the following, the differences from Embodiment 2 will be described mainly, and the description of the common matters will be omitted or simplified.

[4-1. Configuration]

First, a configuration of a semiconductor device according to Embodiment 4 will be described with reference to FIG. 15.

FIG. 15 is a cross-sectional view of semiconductor device 300 according to Embodiment 4. As shown in FIG. 15, semiconductor device 300 includes semiconductor chips 341, 342, and 343 in place of semiconductor chips 141, 142, and 143 as compared to semiconductor device 100 shown in FIG. 6. In addition to the configuration shown in FIG. 6, lower substrate 110 is provided with electrodes 381, 382, and 383. Semiconductor device 300 further includes wires 391, 392, and 393.

Semiconductor chips 341, 342, and 343 are each an example of the first member that is a semiconductor element. Semiconductor chips 341, 342, and 343 are placed between lower substrate 110 and upper substrate 120 not to overlap each other in a plan view of lower substrate 110. In this embodiment, semiconductor chips 341, 342, and 343 are each an element including three electrodes.

FIG. 16 includes (a) a top view, (b) a side view, and (c) a bottom view showing a configuration of each of semiconductor chips 341, 342, and 343 of semiconductor device 300 according to this embodiment. Semiconductor chips 341, 342, and 343 are specific examples of semiconductor chip 40 described in Embodiment 1 and have the same configuration. In the following, semiconductor chip 341 will be described as a representative example.

Semiconductor chip 341 is a semiconductor element, such as a field-effect transistor (FET) or an insulated gate bipolar transistor (IGBT), including three external electrodes. As shown in FIG. 16, semiconductor chip 341 includes chip body 345, lower electrode 346, and upper electrodes 347 and 348.

Chip body 345 is the body of an element formed on a substrate containing, as a main component, silicon carbide (SiC), silicon (Si), gallium nitride (GaN), gallium oxide (GaO), diamond, or any other suitable component. Chip body 345 is in the shape of a flat rectangular parallelepiped. The size of chip body 345 is not particularly limited. Each side length falls within a range from 1 mm to 20 mm. The thickness falls within a range from 0.01 mm to 0.5 mm.

Lower electrode 346 is provided on the lower surface of chip body 345. Lower electrode 346 has a single-layer structure or a multi-layer structure of metal or a metal alloy. For example, lower electrode 346 has a multilayer structure of titanium (Ti), nickel (Ni), and silver (Ag) stacked in this order from chip body 345, but is not limited thereto. For example, the outermost layer (i.e., the lowermost layer) of lower electrode 346 may be made of gold (Au).

Upper electrodes 347 and 348 are provided on the upper surface of chip body 345. Upper electrodes 347 and 348 each have a single-layer structure or a multi-layer structure of metal or a metal alloy. For example, upper electrodes 347 and 348 may have each a multilayer structure of titanium (Ti), nickel (Ni), and silver (Ag) stacked in this order from chip body 345, but is not limited thereto. For example, the outermost layers (i.e., the uppermost surfaces) of upper electrodes 347 and 348 may be made of gold (Au).

If semiconductor chip 341 is a transistor, lower electrode 346, upper electrode 347, and upper electrode 348 correspond to the gate electrode, the source electrode, and the drain electrode, respectively, or the base electrode, the emitter electrode, and the collector electrode, respectively. For example, lower electrode 346 is the drain electrode, upper electrode 347 is the source electrode, and upper electrode 348 is the gate electrode. Lower electrode 346 is provided to cover almost the entire lower surface of chip body 345. Upper electrodes 347 and 348 are provided to cover almost the entire region of chip body 345 not to come into contact with each other. The upper surface of upper electrode 347 is the upper surface of semiconductor chip 341, and connected to the first main surface (i.e., main surface 11A) of corresponding bonding sheet pair 30 (i.e., bonding sheet pair 151, 152, or 153). Upper electrode 348 is connected to electrode 381, 382, or 383 on lower substrate 110 by wire 391, 392, or 393.

Electrodes 381, 382, and 383 are in one-to-one correspondence to semiconductor chips 341, 342, and 343. Note that electrodes 381, 382, and 383 may be electrically connected to each other, or electrically connected to at least one of electrodes 116, 117, or 118. Electrodes 381, 382, and 383 contain a conductive material as a main component. For example, electrodes 381, 382, and 383 are made of metal such as copper (Cu).

Wires 391, 392, and 393 are conductive wire rods. Wires 391, 392, and 393 are made of a metal material such as gold (Au), copper (Cu), or aluminum (Al).

As shown in FIG. 15, wire 391 electrically connects upper electrode 348 (not shown in FIG. 15) of semiconductor chip 341 and electrode 381 on lower substrate 110. Wire 392 electrically connects upper electrode 348 (not shown in FIG. 15) of semiconductor chip 342 and electrode 382 on lower substrate 110. Wire 393 electrically connects upper electrode 348 (not shown in FIG. 15) of semiconductor chip 343 and electrode 383 on lower substrate 110.

As in semiconductor device 100 shown in FIG. 6, in semiconductor device 300 shown in FIG. 15, bonding sheet pairs 151, 152, and 153 are placed in different bonding states to absorb the height differences of the upper surfaces of semiconductor chips 341, 342, and 343. At this time, bonding sheet pairs 151, 152, and 153 are placed no to cover upper electrodes 348 of semiconductor chips 341, 342, and 343 to secure the connecting points of wires 391, 392, and 393, respectively.

FIG. 17 shows an example of absorbing inclinations of the upper surfaces of semiconductor chips 341, 342, and 343. FIG. 17 is a cross-sectional view showing another example of the semiconductor device according to this embodiment. Semiconductor device 301 shown in FIG. 17 have the same elements as semiconductor device 300 shown in FIG. 15.

As in semiconductor device 101 shown in FIG. 9, in semiconductor device 301 shown in FIG. 17, bonding sheet pairs 151, 152, and 153 are placed in different bonding states to absorb the inclinations of the upper surfaces of semiconductor chips 341, 342, and 343, respectively. At this time, bonding sheet pairs 151, 152, and 153 are placed not to cover upper electrodes 348 of semiconductor chips 341, 342, and 343 to secure the connecting points of wires 391, 392, and 393, respectively.

As described above, in semiconductor device 300 or 301 according to this embodiment, the bonding sheet does not cover a part of the upper surface of each semiconductor chip. Accordingly, the semiconductor device is applicable in the case where a plurality of electrodes are provided on the upper surface of each semiconductor chip. An example has been described in this embodiment where a plurality of semiconductor chips included in semiconductor device 300 or 301 are semiconductor elements of the same type. The configuration is however not limited thereto. Semiconductor device 300 or 301 may include a plurality of semiconductor elements of different types. For example, semiconductor device 300 or 301 may include semiconductor chip 141 and semiconductor chip 341. The semiconductor chips of different types themselves may have different heights. Even if semiconductor chips of different types are provided, the height differences and the inclinations can be absorbed by adjusting the placement of the bonding sheet in accordance with the types of the semiconductor chips.

[4-2. Manufacturing Method]

Now, a method of manufacturing semiconductor device 300 will be described with reference to FIGS. 18A to 18F.

FIGS. 18A to 18F are cross-sectional views showing steps of the method of manufacturing semiconductor device 300 according to this embodiment.

First, as shown in FIG. 18A, lower substrate 110 is prepared. For example, lower substrate 110 is obtained by forming a metal film made of copper, for example, on each of the upper and lower surfaces of insulating layer 114 and then patterning the metal film as necessary. Note that the obtainment of lower substrate 110 is not limited thereto. Alternatively, lower substrate 110 formed in advance may be used. In this embodiment, not only electrodes 116, 117, and 118 but also electrodes 381, 382, and 383 are provided on the upper surface of insulating layer 114.

Next, as shown in FIG. 18B, bonding members 131, 132, and 133 are placed on the upper surfaces of electrodes 116, 117, and 118, respectively, on lower substrate 110. For example, bonding members 131, 132, and 133 are each a block member (e.g., a Sn-coated bonding material) of silver (Ag) with the surface coated with tin (Sn), or Ag sintering paste.

Then, as shown in FIG. 18C, semiconductor chips 341, 342, and 343 are placed on the upper surfaces of bonding members 131, 132, and 133, respectively. After placing semiconductor chips 341, 342, and 343, bonding members 131, 132, and 133 are bonded by heat treatment. Accordingly, the lower surfaces of bonding members 131, 132, and 133 are bonded to electrodes 116, 117, and 118, respectively. The upper surfaces of bonding members 131, 132, and 133 are bonded to semiconductor chips 341, 342, and 343, respectively.

After that, as shown in FIG. 18D, upper electrodes 348 (not shown) on the upper surfaces of semiconductor chips 341, 342, and 343 and electrodes 381, 382, and 383 on lower substrate 110 are bonded by wires 391, 392, and 393, respectively. The bonding with wires 391, 392, and 393 employs a known wire bonding technique.

Next, as shown in FIG. 18E, bonding sheet pairs 151, 152, and 153 are placed on the upper surfaces of semiconductor chips 341, 342, and 343, respectively. Although not shown in the figure, before bonding the bonding sheet pairs, at least one of the heights or the inclinations of the upper surfaces of semiconductor chips 341, 342, and 343 are measured. Based on the results of measurement, the directions of displacement and the amounts of displacement between the second main surfaces (i.e., main surfaces 12A and 12B) of the bonding sheet pairs corresponding to the semiconductor chips are specified. Specifically, in order to specify the directions of displacement and the amounts of displacement between the second main surfaces, the three-dimensional positions (i.e., x-, y-, and z-coordinates) and rotation angles (θ) between the two bonding sheets are calculated. Alternatively, the directions of displacement and the amounts of displacement between the second main surfaces themselves may be calculated. Based on the calculated three-dimensional positions and rotation angles, lower bonding sheets 151A, 152A, and 153A and upper bonding sheets 151B, 152B, and 153B are placed sequentially. Accordingly, in accordance with the conditions of the heights and the inclinations of the upper surfaces of the semiconductor chips, the second main surfaces of the corresponding bonding sheet pairs are placed in a displaced manner. As indicated by the broken line in FIG. 18E, the upper surfaces (i.e., main surfaces 11B) of bonding sheet pairs 151, 152, and 153 are flush with each other.

Then, as shown in FIG. 18F, upper substrate 120 is placed to cover the upper surfaces of bonding sheet pairs 151, 152, and 153. After placing upper substrate 120, bonding sheet pairs 151, 152, and 153 are bonded by heat treatment. For example, if the bonding sheets of bonding sheet pairs 151, 152, and 153 are made of a Sn-coated bonding material, reflow treatment through formic acid reduction or hydrogen reduction is performed as the heat treatment. Accordingly, the first main surface (i.e., main surface 11A) of the lower, first bonding sheet in each bonding sheet pair is bonded to the corresponding semiconductor chip. The second main surface (i.e., main surface 11B) of the upper, second bonding sheet of each bonding sheet pair is boded to upper substrate 120. The second main surfaces (i.e., main surfaces 12A and 12B) of each bonding sheet pair are bonded. The positional relationship between the first bonding sheet and the second bonding sheet after the bonding is fixed and kept stable. At each bonding point, an alloy of copper (Cu) and tin (Sn) or an alloy of silver (Ag) and tin (Sn) is formed, providing excellent thermal, mechanical, and electrical bonding.

After that, the configuration shown in FIG. 18F is sealed with sealing member 160 such as a resin. Semiconductor device 300 shown in FIG. 15 or semiconductor device 301 shown in FIG. 17 is then manufactured.

As in Embodiment 3, in place of bonding sheet pairs 151, 152, and 153, bonding sheet pairs 251, 252, and 253 and bonding layers 271, 272, 273, 274, 275, 276, 277, 278, and 279 may be provided.

[Embodiment 5]

Now, Embodiment 5 will be described.

Embodiment 5 is different from Embodiment 4 mainly in that each bonding sheet pair bonds a spacer and an upper substrate. In the following, the differences from Embodiment 4 will be described mainly, and the description of the common matters will be omitted or simplified.

First, a configuration of a semiconductor device according to Embodiment 5 will be described with reference to FIG. 19.

FIG. 19 is a cross-sectional view of semiconductor device 400 according to Embodiment 5. As shown in FIG. 19, semiconductor device 400 includes spacers 441, 442, and 443 and bonding layers 471, 472, and 473 in addition to the configuration of semiconductor device 300 shown in FIG. 15.

Spacers 441, 442, and 443 are each an example of the first member to be bonded to a bonding sheet. Spacers 441, 442, and 443 are provided for height adjustment or to secure spaces for bonding wires. Spacers 441, 442, and 443 are placed not to cover upper electrodes 348 of semiconductor chips 341, 342, and 343 to secure the connecting points of wires 391, 392, and 393.

Spacers 441, 442, and 443 are made of a conductive material. Specifically, spacers 441, 442, and 443 contain metal as a main component. For example, spacers 441, 442, and 443 are made of metal or an alloy of copper (Cu), molybdenum (Mo), aluminum (Al) or silicon (Si). Examples of the alloy include a Cu-Mo alloy or an Al-Si alloy. Alternatively, spacers 441, 442, and 443 may be made of graphite. A coating layer (e.g., a plating layer) made of tin (Sn), silver (Ag), gold (Au), or any other suitable material may be formed on the surfaces of spacers 441, 442, and 443.

Bonding layers 471, 472, and 473 are each a member that mechanically, thermally, and electrically bonds two adjacent members. Bonding layers 471, 472, and 473 are conductive . For example, bonding layers 471, 472, and 473 are made of a sintering material of silver (Ag).

Bonding layer 471 bonds the upper surface (i.e., upper electrode 347) of semiconductor chip 341 and the lower surface of spacer 441. Bonding layer 472 bonds the upper surface (i.e., upper electrode 347) of semiconductor chip 342 and the lower surface of spacer 442. Bonding layer 473 bonds the upper surface (i.e., upper electrode 347) of semiconductor chip 343 and the lower surface of spacer 443.

The variations in the placement (i.e., the height differences and the inclinations of the upper surfaces) of semiconductor chips 341, 342, and 343 can be absorbed by adjusting the shapes and the thicknesses of spacers 441, 442, and 443. However, since the variations in the placement of semiconductor chips 341, 342, and 343 may be caused by mounting accuracy, preparing spacers in suitable shapes and with suitable thicknesses in advance is difficult. In this embodiment as well, bonding sheet pairs 151, 152, and 153 are interposed between corresponding spacers and upper substrate 120. This arrangement can absorb the variations in the placement of the spacers (i.e., the semiconductor chips), improving the heat dissipation and the conductivity.

Specifically, as in semiconductor device 100 shown in FIG. 6, in semiconductor device 400 shown in FIG. 19, bonding sheet pairs 151, 152, and 153 are placed in different bonding states to absorb the height differences of the upper surfaces of semiconductor chips 341, 342, and 343, respectively. Bonding sheet pairs 151, 152, and 153 are bonded to not to semiconductor chips but to spacers 441, 442, and 443, respectively. Otherwise, the bonding states of bonding sheet pairs 151, 152, and 153 are the same as those shown in FIGS. 6 and 8.

FIG. 20 shows an example of absorbing inclinations of the upper surfaces of semiconductor chips 341, 342, and 343. FIG. 20 is a cross-sectional view showing another example of the semiconductor device according to this embodiment. Semiconductor device 401 shown in FIG. 20 have the same elements as semiconductor device 400 shown in FIG. 19.

As in semiconductor device 101 shown in FIG. 9, in semiconductor device 401 shown in FIG. 20, bonding sheet pairs 151, 152, and 153 are placed in different bonding states to absorb the inclinations of the upper surfaces of semiconductor chips 341, 342, and 343. Bonding sheet pairs 151, 152, and 153 are bonded not to semiconductor chips but to spacers 441, 442, and 443. Otherwise, the bonding states of bonding sheet pairs 151, 152, and 153 are the same as those shown in FIGS. 9 and 10.

The method of manufacturing semiconductor device 400 or 401 according to this embodiment is the same as the manufacturing methods described in Embodiments 2 to 4, and the description will be omitted.

As in Embodiment 3, in place of bonding sheet pairs 151, 152, and 153, bonding sheet pairs 251, 252, and 253 and bonding layers 271, 272, 273, 274, 275, 276, 277, 278, and 279 may be provided. In place of at least one of semiconductor chips 341, 342, or 343, semiconductor chip 141, 142, or 143 may be provided.

[Embodiment 6]

Now, Embodiment 6 will be described.

In Embodiment 6, a method of manufacturing the semiconductor devices according to Embodiments 2 to 5 described above will be described. In the following, the differences from Embodiments 1 to 5 will be described mainly, and the description of the common matters will be omitted or simplified.

FIG. 21 is a block diagram of apparatus 500 for manufacturing a semiconductor device according to this embodiment. As shown in FIG. 21, manufacturing apparatus 500 includes first mounter 510, second mounter 520, and measure 530.

First mounter 510 and second mounter 520 are component mounting apparatuses. Note that first mounter 510 and second mounter 520 may be included in one component mounting apparatus or may each include a plurality of component mounting apparatuses. The component mounting apparatus may include a reflow furnace or a high-temperature furnace for heat treatment.

Measure 530 measures at least one of the height or the inclination of the upper surface of each first member. Measure 530 is an optical ranging apparatus that measures the distance to a point of measuring the upper surface of the first member, for example, by radiating light to the point and detecting the reflected light. Note that measure 530 may be a camera that images the upper surface of the first member. As long as measuring at least one of the height or the inclination of the upper surface of the first member, the configuration of measure 530 is not particularly limited.

Specific processes of first mounter 510, second mounter 520, and measure 530 will be described with reference to FIGS. 22 and 23A to 23K.

FIG. 22 is a flowchart showing a method of manufacturing a semiconductor device according to this embodiment. FIGS. 23A to 23K are cross-sectional views for illustrating a step in an operation of the apparatus for manufacturing a semiconductor device according to this embodiment.

As shown in FIG. 22, first, one or more bonding sheet pairs 30 are prepared (S10). For example, manufacturing apparatus 500 may include a manufacturer that manufactures bonding sheets 10. For example, the manufacturer forms base material 20 using a mold, and forms covering layers 21 and 22 by plating the surface thereof. Note that the plating is not necessarily performed.

Next, a first substrate with one or more first members (e.g., semiconductor chips or spacers) is prepared (S12). The first members are semiconductor chips or spacers. For example, as shown in FIG. 23A, manufacturing apparatus 500 prepares lower substrate 110 and places bonding members 131 and 132. Bonding members 131 and 132 are placed by printing, application using a dispenser, or mounting a sheet member. Next, as shown in FIG. 23B, semiconductor chips 141 and 142 are held by suction nozzles 601 and 602, respectively. Semiconductor chips 141 and 142 are located in a predetermined storage such as a tray. Suction nozzles 601 and 602 each pick up the semiconductor chips from the tray one by one, hold each chip, and move the chip to the mounting point. Then, as shown in FIG. 23C, semiconductor chips 141 and 142 are placed (i.e., desorbed) on the upper surfaces of bonding members 131 and 132, respectively. After that, semiconductor chips 141 and 142 and bonding members 131 and 132 are bonded by heat treatment. Note that suction nozzles 601 and 602 are included in first mounter 510 or second mounter 520. The positions of the members and the heat treatment are performed by, for example, first mounter 510 or second mounter 520.

FIG. 23D shows an example where the heights and inclinations of the upper surfaces of semiconductor chips 141 and 142 are different. The variations may occur when placing bonding members 131 and 132, mounting semiconductor chips 141 and 142, at the time of heat treatment, or any other occasions.

After that, measure 530 measures at least one of the height or the inclination of the upper surface of each first member (S14). For example, as shown in FIG. 23E, laser displacement meters 611 and 612 measure the three-dimensional positions (i.e., x-, y-, and z-coordinates) of four points of the upper surfaces of semiconductor chips 141 and 142 as shown in FIG. 4A, and calculates the heights and the inclinations of the upper surfaces based on the results of measurement. Laser displacement meters 611 and 612 are each an example of measure 530. Based on the result of calculation, manufacturing apparatus 500 specifies the directions of displacement and the amounts of displacement between the second main surfaces of corresponding bonding sheet pairs 30. Specifically, manufacturing apparatus 500 specifies the locations and the orientations (i.e., the rotation angles) of the first and second bonding sheets. For example, manufacturing apparatus 500 includes a non-volatile memory that stores programs for calculation and identification, a volatile memory that is a transitory storage area for executing the programs, input/output ports, and a processor that executes the programs, and other suitable elements. Note that the calculation and identification may be performed not by a processor executing programs but by an electronic circuit such as an integrated circuit as hardware.

Next, first mounter 510 places a bonding sheet pair, which is a pair of sheets including the first bonding sheet and the second bonding sheet, on the upper surface of the first member in a displaced manner in the direction of inclination and/or rotation (S16). If a plurality of first members (e.g., semiconductor chips or spacers) are provided on the first substrate, first mounter 510 places a plurality of bonding sheet pairs on the upper surfaces of corresponding first members. For example, first mounter 510 places the bonding sheet pairs on the upper surfaces of the corresponding semiconductor chips. At this time, first mounter 510 displaces the second main surfaces of the first bonding sheet and the second bonding sheet, based on at least one of the height or the inclination of the upper surface of the first member measured by measure 530.

Specifically, as shown in FIG. 23F, bonding sheets 151A and 152A are held by suction nozzles 621 and 622, respectively. Bonding sheets 151A and 152A are located in a predetermined storage such as a tray. Suction nozzles 621 and 622 each pick up the semiconductor chips from the tray one by one, hold each chip, and move the chip to the mounting point. Then, as shown in FIG. 23G, bonding sheets 151A and 152A are placed (i.e., desorbed) on the upper surfaces of semiconductor chips 141 and 142, respectively. At this time, bonding sheets 151A and 152A are placed at locations and orientations (i.e., rotation angles) specified based on the result of measurement. Similarly, as shown in FIG. 23H, bonding sheets 151B and 152B are held by suction nozzles 621 and 622, respectively. Bonding sheets 151B and 152B are located in a predetermined storage such as a tray. Suction nozzles 621 and 622 each pick up the bonding sheets from the tray one by one, hold each bonding sheet, and move the bonding sheet to the mounting point. Then, as shown in FIG. 23I, bonding sheets 151B and 152B are placed (i.e., desorbed) on the upper surfaces of semiconductor chips 141 and 142, respectively. At this time, bonding sheets 151B and 152B are placed at locations and orientations (i.e., rotation angles) specified based on the result of measurement.

Next, second mounter 520 places a second substrate, which is a second member, to cover one or more bonding sheet pairs (S18). For example, second mounter 520 places upper substrate 120 to cover a plurality of bonding sheet pairs. Specifically, as shown in FIG. 23J, upper substrate 120 is held by suction nozzle 630. Upper substrate 120 is located in a predetermined storage such as a tray. Suction nozzle 630 picks up upper substrate 120 from the tray, holds upper substrate 120, and moves upper substrate 120 to the mounting point. Then, as shown in FIG. 23K, upper substrate 120 is placed on the upper surfaces of bonding sheets 151B and 152B (i.e., desorbed). After that, semiconductor chip 141, bonding sheets 151A and 151B, semiconductor chip 142, and bonding sheets 152A and 152B are bonded by heat treatment. In addition, bonding sheets 151B and 152B and upper substrate 120 are bonded. As necessary, a semiconductor device can be manufactured by molding lower substrate 110 and upper substrate 120 collectively using a resin, for example.

As described above, the distance and inclination between the first main surfaces of the first and second bonding sheets can be changed by adjusting the positional relationship between the second main surfaces of the first and second bonding sheets. Accordingly, by placing the first and second bonding sheets with a suitable positional relationship in accordance with the locations of the first members, the variations in the placement of the first members can be absorbed.

[Other Embodiments]

While the bonding sheet, the semiconductor device, the method of manufacturing the semiconductor device, and the apparatus for manufacturing the semiconductor device according to one or more aspects have been described above based on the embodiments, the present disclosure is not limited to the embodiments. The present disclosure may include forms obtained by various modifications to the foregoing embodiments that can be conceived by those skilled in the art or forms achieved by freely combining the elements in different embodiments without departing from the scope and spirit of the present disclosure.

For example, a bonding sheet in the shape of a rectangular parallelepiped in which one of the main surfaces is inclined with respect to the other is raised as an example in the embodiments described above. The shape of the bonding sheet is however not limited thereto. For example, like bonding sheets 50A and 50B shown in FIG. 24, each bonding sheet may be in a shape in which one of the main surfaces (e.g., the upper surface) of a flat cylinder is inclined with respect to the other (e.g., the lower surface). Note that FIG. 24 is a perspective view showing a variation of bonding sheet pair 50.

Each bonding sheet may be in a shape in which one of the main surfaces (e.g., the upper surface) of a flat elliptical cylinder is inclined with respect to the other (e.g., the lower surface). Alternatively, each bonding sheet may be in a shape in which one of the main surfaces (e.g., the upper surface) of a flat polygonal prism, such as a pentagonal prism, a hexagonal prism, or an octagonal prism, is inclined with respect to the other (e.g., the lower surface). Alternatively, each bonding sheet may be in a shape in which one of the main surfaces (e.g., the upper surface) of a flat truncated pyramid is inclined with respect to the other (e.g., the lower surface). The bonding sheet pair may include two bonding sheets in different shapes and sizes.

For example, while a case has been described above in the embodiments where main surface 11 is an example of the first main surface to be bonded to the first member or the second member, the first main surface is not limited thereto. Main surface 12 may be an example of the first main surface to be bonded to the first member or the second member. In this case, main surface 11 is an example of the second main surface. That is, main surfaces 11 of two bonding sheets 10 are bonded to each other.

For example, while an example has been described where the semiconductor chips and the bonding sheet pairs are in one-to-one correspondence, the configuration is not limited thereto. For example, the upper surface of each semiconductor chip may be provided with a plurality of bonding sheet pairs. Alternatively, if the upper surfaces of the plurality of semiconductor chips are at the same height and inclination, one bonding sheet pair may be provided which is bonded to the upper surfaces of the plurality of semiconductor chips.

For example, the semiconductor device includes only one semiconductor chip (first member). Even if the upper surface of one semiconductor chip is inclined, the inclination can be absorbed utilizing a bonding sheet pair. That is, the lower substrate (first substrate) and the upper substrate (second substrate) can be placed in parallel to each other.

Various modifications, replacements, additions, and omissions can be made to the embodiments described above within the scope of the claims and their equivalents.

[Industrial Applicability]

The present disclosure is applicable as a bonding sheet, a semiconductor device, a method of manufacturing a semiconductor device, and an apparatus for manufacturing a semiconductor device, for example, as a semiconductor device of a power module.

[Reference Signs List]

10, 10A, 10B, 50A, 50B, 151A, 151B, 152A, 152B, 153A, 153B, 251A, 251B, 252A, 252B, 253A, 253B bonding sheet
11, 11A, 11B, 12, 12A, 12B, 13, 14 main surface
20 base material
21, 22 covering layer
30, 50, 151, 152, 153, 251, 252, 253 bonding sheet pair
40, 141, 142, 143, 341, 342, 343 semiconductor chip
100, 101, 200, 201, 300, 301, 400, 401 semiconductor device

110 lower substrate
112, 122 heat sink
114, 124 insulating layer
116, 117, 118, 126, 381, 382, 383 electrode
120 upper substrate
131, 132, 133 bonding member
145, 345 chip body
146, 346 lower electrode
147, 347, 348 upper electrode
160 sealing member
271, 272, 273, 274, 275, 276, 277, 278, 279, 471, 472, 473 bonding layer
391, 392, 393 wire
441, 442, 443 spacer
500 manufacturing apparatus
510 first mounter
520 second mounter
530 measure
601, 602, 621, 622, 630 suction nozzle
611, 612 laser displacement meter

## Claims

1. A bonding sheet that is one of a pair of sheets for bonding a first member and a second member, the bonding sheet comprising:

    a first main surface to be bonded to the first member or the second member; and
    a second main surface at a side opposite to the first main surface, wherein
    the second main surface is inclined with respect to the first main surface, and
    the bonding sheet is conductive.

2. The bonding sheet according to claim 1, further comprising:

    a metal layer having a third main surface, and a fourth main surface at a side opposite to the third main surface;
    a first covering layer that covers at least a part of the third main surface; and
    a second covering layer that covers at least a part of the fourth main surface, wherein
    the first main surface is a part of a surface of the first covering layer, and
    the second main surface is a part of a surface of the second covering layer.

3. The bonding sheet according to claim 2, wherein
    each of the first covering layer and the second covering layer contains tin or a tin alloy as a main component.

4. The bonding sheet according to claim 2, wherein

    the third main surface is parallel to the first main surface, and
    the fourth main surface is parallel to the second main surface.

5. A semiconductor device comprising:

    a pair of sheets including a first bonding sheet and a second bonding sheet each being the bonding sheet according to any one of claims 1 to 4;
    the first member; and
    the second member, wherein
    the first member is a semiconductor element or a spacer,
    the first main surface of the first bonding sheet is bonded to the first member,
    the first main surface of the second bonding sheet is bonded to the second member, and
    the second main surfaces of the first bonding sheet and the second bonding sheet are bonded to each other.

6. The semiconductor device according to claim 5, wherein
   the second member is a substrate or a spacer.

7. The semiconductor device according to claim 5, wherein
   the first main surface of the first bonding sheet is larger than the first member in a plan view of the first main surface.

8. The semiconductor device according to claim 5, further comprising:

   a first substrate;
   a second substrate being the second member parallel to the first substrate;
   a plurality of first members, each being the first member, placed between the first substrate and the second substrate so as not to overlap each other in a plan view of the first substrate; and
   pairs of sheets, each being the pair of sheets, in one-to-one correspondence to the plurality of first members, wherein
   in each of the pairs of sheets,

   the first main surface of the first bonding sheet is bonded to a corresponding one of the plurality of first members, and
   the first main surface of the second bonding sheet is bonded to the second substrate.

9. The semiconductor device according to claim 8, wherein
   in at least one of the pairs of sheets, one of the second main surfaces is bonded in a displaced manner from another one of the second main surfaces.

10. The semiconductor device according to claim 9, wherein
    the second main surfaces are displaced in a direction of inclination between the second main surfaces.

11. The semiconductor device according to claim 9, wherein
    the second main surfaces are displaced in a direction of rotation about an axis extending in a direction orthogonal to the second main surfaces.

12. The semiconductor device according to claim 9, wherein
    surfaces of at least two of the plurality of first members bonded to corresponding ones of the first main surfaces are at different heights from the first substrate.

13. The semiconductor device according to claim 9, wherein
    a surface of at least one of the plurality of first members bonded to a corresponding one of the first main surfaces is inclined with respect to the first substrate.

14. A method of manufacturing a semiconductor device, the method comprising:

    preparing pairs of sheets each including a first bonding sheet and a second bonding sheet, each being the bonding sheet according to any one of claims 1 to 4;
    preparing a first substrate on which a plurality of first members, each being the first member, are placed not to overlap each other in a plan view;
    measuring at least one of heights of upper surfaces of the plurality of first members from the first substrate or inclinations of upper surfaces of the plurality of first members with respect to the first substrate;
    placing the pairs of sheets on the upper surfaces of corresponding ones of the plurality of first members; and
    placing a second substrate that is the second member so as to cover the pairs of sheets,
    the placing of the pairs of sheets includes placing the second main surfaces of at least one of the pairs of sheets in a displaced manner based on at least one of the heights or the inclinations of the upper surfaces of the plurality of first members.

15. The method according to claim 14, wherein
    the placing of the pairs of sheets includes:

    specifying directions and amounts of displacement of the second main surfaces of the pairs of sheets based on at least one of the heights or the inclinations of the upper surfaces of the plurality of first members; and

placing the second main surfaces in a displaced manner based on the directions and the amounts of displacement specified.

16. The method according to claim 14, wherein

the measuring includes measuring heights of the upper surfaces of the plurality of first members from the first substrate, and
the placing of the pairs of sheets includes placing the pairs of sheets on the upper surfaces of the plurality of first members, while displacing one of the first bonding sheet or the second bonding sheet of at least one of the pairs of sheets from another one in a direction of inclination of the second main surface based on the heights of the upper surfaces of the plurality of first members.

17. The method according to claim 14, wherein

the measuring includes measuring inclinations of the upper surfaces of the plurality of first members with respect to the first substrate, and
the placing of the pairs of sheets includes placing the pairs of sheets on the upper surfaces of the plurality of first members, while displacing one of the first bonding sheet or the second bonding sheet of at least one of the pairs of sheets from an other one of the first bonding sheet or the second bonding sheet in a direction of rotation about an axis extending in a direction orthogonal to the second main surfaces based on the inclinations of the upper surfaces of the corresponding one of the plurality of first members.

18. A method of manufacturing a semiconductor device, the method comprising:

preparing a pair of sheets including a first bonding sheet and a second bonding sheet, each being the bonding sheet according to any one of claims 1 to 4;
preparing a first substrate provided with the first member;
measuring an inclination of an upper surface of the first member with respect to the first substrate;
placing the pair of sheets on the upper surface of the first member, while displacing one of the first bonding sheet or the second bonding sheet from an other one of the first bonding sheet or the second bonding sheet in a direction of rotation about an axis extending in a direction orthogonal to the second main surface based on the inclination; and
placing a second substrate that is the second member so as to cover the pair of sheets.

19. An apparatus for manufacturing a semiconductor device, the apparatus comprising:

a first mounter that places pairs of sheets each including a first bonding sheet and a second bonding sheet, each being the bonding sheet according to any one of claims 1 to 4, on upper surfaces of a plurality of first members, each being the first member, placed on a first substrate not to overlap each other in a plan view;
a second mounter that places a second substrate that is the second member so as to cover the pairs of sheets; and
a measure that measures at least one of heights of the upper surfaces of the plurality of first members from the first substrate or inclinations of the upper surfaces of the plurality of first members with respect to the first substrate, wherein
the first mounter places the second main surfaces of at least one of the pairs of sheets in a displaced manner based on at least one of the heights or the inclinations of the upper surfaces of the plurality of first members.

20. An apparatus for manufacturing a semiconductor device, the apparatus comprising:

a first mounter that places a pair of sheets including a first bonding sheet and a second bonding sheet, each being the bonding sheet according to any one of claims 1 to 4, on an upper surface of the first member on a first substrate;
a second mounter that places a second substrate that is the second member so as to cover the pair of sheets; and
a measure that measures an inclination of the upper surface of the first member with respect to the first substrate, wherein
the first mounter places the pair of sheets on the upper surface of the first member, while displacing one of the first bonding sheet or the second bonding sheet from another in a direction of rotation about an axis extending in a direction orthogonal to the second main surface based on the inclination.

EP 4 756 867 A1

FIG. 1

FIG. 2

# FIG. 3A

EP 4 756 867 A1

EP 4 756 867 A1

FIG. 3C

## FIG. 4A

## FIG. 4B

# FIG. 5

FIG. 6

EP 4 756 867 A1

FIG. 7

(a)

141, 142, 143

y
z ⊙ → x

145
147

(b)

z
y ⊗ → x

147
145
146

(c)

z
y ⊗ → x

145
146

FIG. 8

151
151A, 151B
152
152B
152A
153A
153
153B

y
z ⊙ → x

141
142
143

EP 4 756 867 A1

FIG. 9

101

# FIG. 10

# FIG. 11A

## FIG. 11B

110 {
116
114
112

131    117 132    118 133

## FIG. 11C

110 {
116
114
112

131 141    117 132 142    118 133 143

# FIG. 11D

# FIG. 11E

EP 4 756 867 A1

# FIG. 12

# FIG. 13

EP 4 756 867 A1

## FIG. 14A

## FIG. 14B

## FIG. 14C

## FIG. 14D

## FIG. 14E

## FIG. 14F

# FIG. 15

EP 4 756 867 A1

FIG. 16

341, 342, 343

(a)

y

z ⊙ → x

345

348

347

(b)

z

y ⊗ → x

347

345

346

(c)

z ⊗ → x

y

345

346

FIG. 17

## FIG. 18A

110 { 116, 114, 112

381  117    382  118    383

## FIG. 18B

110 { 116, 114, 112

131  381  117  132  382  118  133  383

## FIG. 18C

110 { 116, 114, 112

131  341  381  117  132  342  382  118  133  343  383

## FIG. 18D

## FIG. 18E

## FIG. 18F

# FIG. 19

FIG. 20

EP 4 756 867 A1

# FIG. 21

Manufacturing apparatus — 500

First mounter — 510

Measure — 530

Second mounter — 520

# FIG. 22

```
        ┌─────────────┐
        │    Start    │
        └─────────────┘
               │
               ▼
   ┌───────────────────────┐
   │   Prepare one or more │  ── S10
   │   bonding sheet pairs │
   └───────────────────────┘
               │
               ▼
   ┌───────────────────────┐
   │  Prepare first substrate │
   │  arranged with one or │  ── S12
   │    more first members │
   └───────────────────────┘
               │
               ▼
   ┌───────────────────────┐
   │  Measure at least one of │
   │   height or inclination │  ── S14
   │     of first member   │
   └───────────────────────┘
               │
               ▼
   ┌───────────────────────┐
   │ Place bonding sheet pair on │
   │ first member in displaced │  ── S16
   │  manner in direction of │
   │ inclination and/or rotation │
   └───────────────────────┘
               │
               ▼
   ┌───────────────────────┐
   │   Place second substrate │  ── S18
   └───────────────────────┘
               │
               ▼
        ┌─────────────┐
        │     End     │
        └─────────────┘
```

## FIG. 23A

## FIG. 23B

## FIG. 23C

FIG. 23D

FIG. 23E

## FIG. 23F

## FIG. 23G

## FIG. 23H

## FIG. 23I

## FIG. 23J

# FIG. 23K

FIG. 24

50

50B

50A

**INTERNATIONAL SEARCH REPORT**

International application No.

**PCT/JP2024/025725**

| A. | CLASSIFICATION OF SUBJECT MATTER |
|---|---|

*H01L 21/52*(2006.01)i
FI:   H01L21/52 E

According to International Patent Classification (IPC) or to both national classification and IPC

| B. | FIELDS SEARCHED |
|---|---|

Minimum documentation searched (classification system followed by classification symbols)

H01L21/52

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2009-152362 A (MITSUBISHI HEAVY INDUSTRIES, LTD.) 09 July 2009 (2009-07-09) paragraphs [0014], [0021]-[0027], fig. 6 | 1-10, 12-16, 19 |
| A | | 11, 17-18, 20 |
| Y | JP 2010-245373 A (PANASONIC CORPORATION) 28 October 2010 (2010-10-28) paragraphs [0048]-[0059], fig. 1, 6 | 1-10, 12-16, 19 |
| A | | 11, 17-18, 20 |
| Y | JP 2015-73054 A (MITSUBISHI ELECTRIC CORPORATION) 16 April 2015 (2015-04-16) paragraphs [0011]-[0036], fig. 1-6 | 8-10, 12-16, 19 |
| A | | 11, 17-18, 20 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **09 September 2024** | **17 September 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/025725**

| Patent document cited in search report | | | Publication date (day/month/year) | Patent family member(s) | Publication date (day/month/year) |
|---|---|---|---|---|---|
| JP | 2009-152362 | A | 09 July 2009 | (Family: none) | |
| JP | 2010-245373 | A | 28 October 2010 | (Family: none) | |
| JP | 2015-73054 | A | 16 April 2015 | (Family: none) | |

Form PCT/ISA/210 (patent family annex) (July 2022)

## REFERENCES CITED IN THE DESCRIPTION

**Patent documents cited in the description**

- WO 2022049641 A
- JP 2021002563 A

- JP 2021180290 A